# EUROPEAN PATENT APPLICATION

(11) **EP 4 597 142 A1**
(43) Date of publication of application: **06.08.2025**
(21) Application number: 24154676.1
(22) Date of filing: 30.01.2024
(51) Int. Cl.: G01R 33/32, G01R 33/36, G01R 33/44

(54) **QUANTUM SENSOR-INTEGRATED MAGNETIC RESONANCE IMAGING COIL ASSEMBLY**

(71) Applicant: Koninklijke Philips N.V., 5656 AG Eindhoven (NL)
(72) Inventor: HAHN, Artur, Eindhoven (NL); LEUSSLER, Christoph Günther, Eindhoven (NL)
(74) Representative: Philips Intellectual Property & Standards

(57) **Abstract**

Disclosed herein is a magnetic resonance imaging (MRI) coil assembly comprising: a set of one or more quantum sensors and associated set of one or more radio frequency coils respectively, wherein each radio frequency coil of the set of one or more radio frequency coils is configured to perform radio frequency excitation in an object to be imaged for inducing a magnetic resonance signal from the object; wherein each quantum sensor of the set of one or more quantum sensors is configured to receive a signal induced by the magnetic resonance signal in the respective radio frequency coil and provide an optical signal representing the MRI signal through an optical link. The MRI coil assembly comprises an optical signal processing unit that is configured to receive through the optical links the one or more optical signals and to digitize the one or more optical signals.

## Description

### FIELD OF THE INVENTION

The invention relates to medical acquisition systems, in particular to a quantum sensor-integrated magnetic resonance imaging coil assembly.

### BACKGROUND OF THE INVENTION

Magnetic Resonance Imaging (MRI) is a non-invasive imaging technology that produces detailed anatomical images. It is often used for disease detection, diagnosis, and treatment monitoring. It is based on sophisticated technology that excites and detects the change in the direction of the rotational axis of protons found in the water that makes up living tissues.

An MRI apparatus or a hybrid MRI apparatus (e.g., MR LINAC) may create a strong magnetic field around a patient, and when radio waves are sent towards the magnetic field, the protons in the body respond to the radio waves by aligning their rotational axis. When the radio waves are turned off, the protons return to their normal alignment and in doing so, they emit MRI signals.

These emitted MRI signals are received by the MRI apparatus and are measured to create an image of the body. The strength of the MRI signal emitted by the protons may also be measured and this may provide information about the type of tissue the protons are in and about certain diseases.

The MRI signal reception may be done using classical coil designs, e.g., a round antenna connected to a capacitor C to form an inductive circuit with inductivity L and electric resistance R. The precessing magnetization of a sample in the magnetic field B0 may irradiate circularly polarized electromagnetic (EM) radiation, which induces an AC voltage in the pickup coil. This would go through pre-amplification and digitization in order to be processed for reconstruction.

With current technology, many macroscopic material and component imperfections may contribute to an overall noisy acquired signal. Also, sensitivity may be limited by the acquisition hardware properties and microscopic pureness of material. Further, classical coils may only be sensitive to certain frequencies, for which the coil has been tuned, so different coils may need to be designed for different field strength MRIs.

### SUMMARY OF THE INVENTION

The invention provides for a magnetic resonance imaging (MRI) coil assembly, a computer program, and a method in the independent claims. Embodiments are given in the dependent claims.

Example embodiments may provide a new generation of MRI pickup hardware using quantum sensing, possibly enabling "photon-counting" level sensitivity in MRI and orders of magnitude signal-to-noise ratio (SNR) increase. The quantum sensors may be MR-safe and non-coupling, using quantized energy levels of highly excited atoms (e.g., Rydberg-states) to detect even very weak fields and perturbations with high sensitivity in absolute physical units. Eliminating several sources of noise, could enable MRI with unprecedented quality, especially for mid and low field MRI. For example, one quantum sensor may be used for all medical field strengths, nuclei, and even electron magnetic resonance. Due to the calibration-less absolute electric and magnetic field measurements attainable from the quantum sensors and their usage according to the present subject matter to determine the location of a radiating source and Doppler shifts, as well as measuring the 3-component vector magnetic flux B = (Bx, By, Bz), new ways of using MRI, magnetic particle imaging, or the development of entirely new imaging methods could follow adoption.

According to an aspect of the invention, there is provided a magnetic resonance imaging (MRI) coil assembly. The MRI coil assembly comprises a set of one or more quantum sensors. The MRI coil assembly also comprises an associated set of one or more radio frequency (RF) coils. The set of one or more radio frequency coils are associated with the set of one or more quantum sensors respectively. Each radio frequency coil of the set of one or more radio frequency coils is configured to perform radio frequency excitation in an object or subject. The object may be an object to be imaged in accordance with MRI technique. The radio frequency excitation is performed for inducing a magnetic resonance signal from the object. Each quantum sensor of the set of one or more quantum sensors is configured to receive a signal induced by the magnetic resonance signal in the respective radio frequency coil. The each quantum sensor is further configured to provide an optical signal representing the MRI signal through an optical link. Additionally, there is provided an optical signal processing unit which is comprised in the MR coil assembly. The optical signal processing unit is configured to receive the one or more optical signals through the one or more optical links from the set of one or more quantum sensors respectively. The optical signal processing unit is configured to digitize the received one or more optical signals.

In one example, the set of one or more quantum sensors may be one quantum sensor. Alternatively, the set of one or more quantum sensors may be an array of two or more quantum sensors. The number of the RF coils is equal to the number of quantum sensors in the MRI coil assembly, wherein each RF coil is associated with a respective quantum sensor. Each quantum sensor may be connected to the optical signal processing unit through a respective optical link. The optical link may comprise one or more fiber optic cables or other suitable means of optical transmission.

The quantum sensor may be a type of sensor that utilizes properties of quantum mechanics to detect magnetic field signals and/or electric field signals. The quantum sensors may be based on various technologies, such as nitrogen-vacancy (NV) centers in diamond, or other quantum systems capable of sensing magnetic and/or electric fields. In one example, the quantum sensor to detect RF fields may be referred to as quantum RF (qRF) sensor.

The quantum sensors may be positioned within the MRI coil assembly to optimize the detection of the magnetic resonance signals. The quantum sensors and associated RF coils may be arranged according to a quantum sensor arrangement. The quantum sensors and associated RF coils may, for example, be arranged in a linear or planar configuration, or in any other suitable arrangement that may allow for efficient and accurate detection of the signals. The radio frequency coils are specifically designed to perform radio frequency excitation in the object being imaged. By applying radio frequency pulses to the object, the radio frequency coils induce a magnetic resonance signal, which may then be detected by the quantum sensors. The radio frequency coils may be of various types, such as surface coils, volume coils, or phased array coils. They may be made of conductive materials, such as copper or aluminum, and may be shaped and sized to optimize the excitation of the magnetic resonance signal in the object.

By combining the capabilities of the quantum sensors and the radio frequency coils, the MRI coil assembly may enable high-resolution imaging of the object. The quantum sensors may provide sensitive and accurate detection of the magnetic resonance signals, while the radio frequency coils may ensure efficient excitation of the signals.

The use of quantum sensors may significantly reduce coil noise as there may be no conducting metals involved; just the quantum sensor and an optical link. The optical signals may be transmitted over long distances without significant loss or degradation, ensuring the accurate representation of the magnetic resonance signal. Furthermore, the optical links used to transmit the optical signals may vary in terms of their length, material, or transmission capabilities. This reduction in noise may particularly be beneficial at lower field strengths of the MRI, where patient noise may be less due to wave propagation effects becoming increasingly negligible at longer wavelength.

The quantum sensors may be small in size (on the µm-mm scale), super lightweight, and may not interfere with or couple with each other like pickup coils may do. These quantum sensors may be attached to flexible, light, blanket-like fabric, enhancing patient comfort and ease of handling. In certain constructions, the quantum sensor may be so sensitive to electromagnetic (EM) radiation that Doppler shifts can be detected even from very slow transmitter (subject) motion.

For example, the set of quantum sensors and associated radio frequency coils may be placed in close proximity to the object being imaged, such as a human body part or a sample in a laboratory setting. The radio frequency coils may emit radio frequency pulses, which excite the magnetic resonance signal in the object. The quantum sensors may detect and measure the resulting magnetic resonance signals.

The quantum sensor may be configured to provide an optical signal that represents the MRI signal. The optical signal may be transmitted through the optical link of the quantum sensor. The optical signal processing unit may be specifically configured to receive the one or more optical signals through the one or more optical links from the set of one or more quantum sensors respectively. The optical signal processing unit may be also designed to digitize the one or more optical signals. The optical signal processing unit may process the digitized optical signals for storing the digitized optical signals, analyzing the digitized optical signals, or transmitting the digitized optical signals to other devices for further processing or visualization. For example, the laser absorption spectrum of the optical signal may be analyzed to derive the desired information e.g., as k-space data.

To illustrate the functionality of the MRI coil assembly, consider an example where the set of quantum sensors consists of three individual quantum sensors. Each quantum sensor is positioned near a different radio frequency coil within the MRI coil assembly. When the magnetic resonance signal is generated by the coils during an MRI scan, each quantum sensor receives a corresponding signal induced by the magnetic resonance. The quantum sensors may then convert these signals into optical signals, which are transmitted through the optical links to the optical signal processing unit. The optical signal processing unit that receives these optical signals may digitize the optical signal. This may involve converting the analog optical signals using an Optical-to-Digital Converter (ODC) into digital form, allowing for further analysis and processing. The digitized signals may then be stored, analyzed, or transmitted to other devices for further processing or visualization.

For example, the optical signal processing unit may incorporate signal processing algorithms to extract specific information from the digitized signals. These algorithms may be designed to identify and analyze specific features or patterns within the MRI signal, providing valuable insights for medical diagnosis or research purposes. For example, the laser absorption spectrum of the optical signal may be analyzed to derive the desired information.

According to one embodiment, the induced signal from the radio frequency coil is a magnetic field signal, an electric field signal or an electromagnetic signal.

According to one embodiment, the set of one or more radio frequency coils are arranged such that the electric field signal is a linearly polarized electric field signal and the magnetic field signal is a linearly polarized magnetic field signal.

This arrangement may enhance the efficiency and accuracy of the MRI system. To achieve this, the set of radio frequency coils may be positioned and oriented within the MRI coil assembly. In one example, the set of one or more radio frequency coils may be arranged by providing a specific structure to each of them e.g., each of the one or more radio frequency coils may be obtained by wounding a copper wire to an LC-circuit and resonating at the Larmor frequency. In another example, the radio frequency coils may be arranged in a parallel configuration, with each radio frequency coil aligned in the same direction. Alternatively, the radio frequency coils may be arranged in a concentric configuration, with each radio frequency coil positioned around a central axis. By arranging the radio frequency coils in this manner, the electric field signal produced by the set of radio frequency coils may be provided linearly polarized. This means that the electric field oscillates in a single plane, providing a more focused and controlled signal. Similarly, the magnetic field signal produced by the radio frequency coils may also be provided linearly polarized, ensuring a consistent and predictable magnetic field distribution. This linear polarization of both the electric and magnetic field signals may offer several advantages in MR imaging. Firstly, it may improve the signal-to-noise ratio, allowing for clearer and more detailed images. The linearly polarized fields may also enable better control over the excitation and manipulation of the nuclear spins in the patient's body, leading to enhanced image contrast and resolution.

According to one embodiment, each quantum sensor of the set of one or more quantum sensors is electrically and/or magnetically coupled with the respective radio frequency coil of the set of one or more radio frequency coils.

The electrical coupling may allow for the transmission of electrical signals between the quantum sensors and the radio frequency coil. By doing so, the quantum sensors may detect and measure the electric fields generated by the radio frequency coil during the MRI scanning process. In an alternative embodiment, the quantum sensors in the MRI coil assembly may be magnetically coupled with the respective radio frequency coils. This magnetic coupling may enable the transfer of magnetic field signals between the quantum sensors and the radio frequency coils. As a result, the quantum sensors may capture the magnetic fields produced by the radio frequency coil during the MRI scanning process.

The electrical and/or magnetic coupling between the quantum sensors and the radio frequency coils may provide a means for the quantum sensors to interact with the respective radio frequency coils and accurately measure the magnetic fields generated during MRI scans. This interaction may allow for the quantum sensors to capture detailed information about the produced MRI signals.

Combining the capabilities of the quantum sensors and the radio frequency coils may provide a hybrid solution. The present subject matter may provide advantageous options of the hybrid solution.

According to one embodiment, each quantum sensor of the set of one or more quantum sensors is placed inside or beside the respective radio frequency coil. This placement may enable the quantum sensor to receive the magnetic field signal. The magnetic field signal may carry information about the target area being imaged. This may provide a first alternative hybrid solution. This first alternative hybrid solution may enable to place the quantum sensor inside of an actual radio frequency coil instead of a capacitor to measure the induced magnetic flux locally inside the radio frequency coil. In this embodiment, the circularly polarized magnetic radiation from the object in the scanner may be converted to a linearly polarized magnetic field oscillation inside the radio frequency coil.

In one example, the quantum sensor is placed inside the respective radio frequency coil. This placement may allow for direct exposure to the magnetic field signals generated during the MRI scanning process. By being positioned within the radio frequency coil, the quantum sensor may capture the magnetic field signals with high precision and accuracy.

Alternatively, the quantum sensor may be positioned beside the respective radio frequency coil. This placement may allow for a slightly different approach to capturing the magnetic field signals. By being positioned beside the radio frequency coil, the quantum sensor may still effectively detect and measure the magnetic field signals, albeit with a slightly different orientation and proximity to the radio frequency coil.

The positioning of the quantum sensor, whether inside or beside the radio frequency coil, may be chosen to optimize the reception of the magnetic field signals. This may ensure that the quantum sensor may accurately capture the necessary data for further processing.

According to one embodiment, each quantum sensor of the set of one or more quantum sensors is placed inside a capacitor of the respective radio frequency coil. This placement may enable the quantum sensor to receive the electric field signal. This may provide a second alternative hybrid solution. In this second alternative hybrid solution, the radio frequency field energy may be focused to an electric field inside the capacitor e.g., using a waveguide similar to a classic pickup coil. By placing the quantum sensor inside the capacitor gap and retrieving the optical signal directly from the sensor laser with optic fibre cables, the optical signals may be processed.

By being placed in this specific location, the quantum sensor may be able to effectively receive the electric field signal. This placement may ensure that the quantum sensor is optimally positioned to capture the desired signals during the MRI process. In operation, the quantum sensor within the capacitor may detect the electric field signal. The electric field signal may carry information about the target area being imaged. The quantum sensor is designed to be highly sensitive, allowing it to accurately capture and measure the electric field signal. Once the electric field signal is captured by the quantum sensor, it may then be processed by the optical signal processing unit.

To reduce noise and increase sensitivity, a third hybrid solution may be provided. The third hybrid solution may be a combination of the first and second hybrid solutions, wherein quantum sensors of the set may be provided in accordance with the first hybrid solution and remaining quantum sensors of the set may be provided in accordance with the second hybrid solution. For example, the quantum sensors may comprise quantum sensors placed inside the respective capacitors for E-field measurement and quantum sensors placed inside the respective radio frequency coils as magnetic flux sensor.

Alternative embodiments of the MRI coil assembly may include different arrangements and configurations of the quantum sensors and radio frequency coils. For example, the quantum sensors may be positioned in a concentric arrangement around the radio frequency coils, or they may be integrated within the radio frequency coils themselves. Similarly, the radio frequency coils may be designed in various shapes and sizes to accommodate different imaging scenarios.

According to one embodiment, the set of one or more quantum sensors are an array of quantum sensors, wherein the optical signal processing unit is configured to process the optical signals using a quantum sensitivity map (QSM).

The array formation may be designed to enhance the sensitivity and resolution of the MRI coil assembly. The quantum sensors may be based on various quantum technologies, such as nitrogen-vacancy (NV) centers in diamond, or other suitable quantum systems. The optical signal processing unit included in the MRI coil assembly may be responsible for processing the optical signals generated by the quantum sensors. The optical signal processing unit may utilize the quantum sensitivity map (QSM) to enhance the accuracy and efficiency of the signal processing. The QSM may be a representation of the sensitivity distribution of the quantum sensors within the array formation. The QSM may provide information about the relative sensitivity of each quantum sensor within the array, allowing the optical signal processing unit to accurately determine the strength and location of the magnetic resonance signals. By utilizing this map, the optical signal processing unit may effectively analyze and interpret the received optical signals. By utilizing the map, the optical signal processing unit may effectively analyze the optical signals and extract the desired magnetic resonance information.

In one example, different array formations of the quantum sensors, such as linear, circular, or three-dimensional arrays, may be utilized depending on the specific requirements of the MRI coil assembly. Additionally, alternative quantum sensor technologies, such as optically pumped magnetometers, may be employed in the MRI coil assembly. The optical signal processing unit may also utilize different signal processing algorithms or techniques to enhance the performance of the system.

According to one embodiment, the set of quantum sensors is configured to be deactivated during RF excitation. This deactivation may ensure that the quantum sensors are not affected by any external magnetic fields present in the environment, such as those generated by nearby electronic devices. The deactivation may, for example, be realized by shortcut the capacitor to switch of the electric field by means of active components such as Micro-Electro-Mechanical Systems (MEMS) or diodes.

The deactivation of the quantum sensors may be achieved through various alternative techniques. One method to deactivate the quantum sensors during RF excitation may be by utilizing a control circuitry that may selectively switch off the quantum sensors. The control circuitry may be integrated into the MRI coil assembly and communicate with the quantum sensors to disable their operation during RF excitation. This may be done by sending control signals to the sensors to turn off their sensing capabilities temporarily. Another method to deactivate the quantum sensors may be by incorporating a shielding mechanism around the sensors. The shielding mechanism may be made of a material that blocks or attenuates the RF signals used for excitation. By surrounding the quantum sensors with this shielding material, the RF excitation signals may be prevented from reaching the quantum sensors, effectively deactivating them during the excitation phase. Alternatively, the deactivation of the quantum sensors may be achieved by adjusting the operating parameters of the sensors themselves. For example, the quantum sensors can be designed to have a specific frequency range of sensitivity. By configuring the quantum sensors to be sensitive to frequencies outside the range of the RF excitation signals, they can be effectively deactivated during the excitation phase.

According to one embodiment, the set of quantum sensors is configured to be deactivated using a shield circuit, wherein the shield circuit is configured to be switched on for deactivating the set of quantum sensors and switched off for activating the set of quantum sensors. This method may enhance the flexibility and functionality of the MRI coil assembly, allowing for precise control over the sensing capabilities.

For example, to activate or deactivate the set of quantum sensors, a control unit may be integrated into the MRI coil assembly. The control unit may be responsible for sending signals to the shield circuit, instructing it to either switch on or switch off. This control unit may be operated manually by a user or can be automated through a computer interface, providing a convenient and efficient means of controlling the activation status of the quantum sensors. For example, the control unit may send a command to the shield circuit, instructing it to switch off. As a result, the set of quantum sensors is activated, allowing them to detect and measure the magnetic fields emanating from the targeted region. In another example, the control unit may send a command to the shield circuit, instructing it to switch on. As a result, the set of quantum sensors is deactivated. When the shield circuit is switched on, it may generate a magnetic field that effectively shields the set of quantum sensors from external magnetic interference. This shielding mechanism may prevent any external magnetic field from affecting the performance of the quantum sensors, ensuring accurate and reliable sensing during the MRI procedure.

Furthermore, alternative embodiments of the shield circuit may be explored. For example, instead of a single shield circuit, multiple shield circuits may be incorporated into the MRI coil assembly. Each shield circuit may be independently controlled, allowing for selective activation or deactivation of specific subsets of the quantum sensors. This modular approach may provide even greater flexibility in tailoring the sensing capabilities to the specific requirements of different MRI scans.

According to one embodiment, the shield circuit is configured to be switched on and off by a PIN switch, a Field-effect transistor, FET, switch or MEMS sensor.

The shield circuit is designed to be switchable, allowing for greater control and flexibility in the MRI imaging process. This switchable feature may be achieved through the use of either a PIN switch or a Field-effect transistor (FET) switch. The PIN switch may be a type of electronic switch that utilizes a diode-like structure to control the flow of current. When the switch is turned on, it may allow current to flow through the shield circuit, effectively activating the shielding function. Conversely, when the switch is turned off, it may interrupt the current flow, deactivating the shielding and allowing for unimpeded signal reception. Alternatively, the shield circuit may be equipped with a Field-effect transistor (FET) switch. FETs are semiconductor devices that can control the flow of current based on an applied voltage. By utilizing a FET switch, the shield circuit may be easily toggled on and off by adjusting the voltage applied to the switch. When the voltage is high, the FET switch may conduct current, activating the shielding. Conversely, when the voltage is low, the FET switch may block current flow, deactivating the shielding.

The switchable shield circuit may offer several advantages in the field of MRI imaging. For example, it may allow for the selective shielding of specific areas or regions of interest within the patient's body by using several switchable shield circuits, each being associated with respective quantum sensors. By activating the shield circuit only in certain areas, the MRI coil assembly may focus on capturing high-quality images of those specific regions, while minimizing interference from surrounding tissues or structures. Furthermore, the switchable shield circuit provides flexibility in adjusting the sensitivity of the MRI coil assembly. By activating the shielding, the assembly may reduce the impact of external electromagnetic interference, resulting in improved signal-to-noise ratio and enhanced image quality. On the other hand, deactivating the shielding may allow for increased sensitivity, which may be beneficial in certain imaging scenarios.

For example, the switchable shield circuit may be controlled through various means. For example, it may be integrated into the MRI system's control software, allowing the operator to easily toggle the shield circuit on or off based on the specific imaging requirements. Additionally, the shield circuit may be designed to automatically switch on or off based on predetermined conditions, such as the presence of certain anatomical structures or the type of imaging sequence being performed or the presence of RF excitations of the RF coils. Another example may be to combine quantum sensors with conventional RF coil preamplifiers and combine their respective outcomes to reconstruct an MR image.

According to one embodiment, the quantum sensor is an Optically pumped magnetometer (OPM) or a solid state spin defect-based quantum sensor. The solid state spin defect-based quantum sensor may, for example, be a diamond-based quantum sensor. This may provide high sensitivity and accuracy, allowing for precise imaging and diagnosis in MRI scans. One embodiment of the quantum sensor is the Optically pumped magnetometer (OPM). The OPM utilizes the principles of quantum physics to detect magnetic fields. It may consist of a vapor cell filled with alkali metal atoms, such as rubidium or cesium. These atoms are optically pumped using laser light, which aligns their spins in a specific direction. When a magnetic field is present, it causes a precession of the aligned spins, which can be detected by measuring the changes in the light absorption of the atoms. The OPM may offer excellent sensitivity and may operate at room temperature, making it a practical choice for the MRI coil assembly.

Another embodiment of the quantum sensor is the diamond-based quantum sensor. This type of sensor utilizes the unique properties of diamond, specifically the presence of nitrogen-vacancy (NV) centers. NV centers may be defects in the diamond lattice where a nitrogen atom replaces a carbon atom, adjacent to a vacant lattice site. These NV centers have electronic spins that can be manipulated and measured to detect magnetic fields. By applying microwave and laser pulses, the NV centers can be initialized, manipulated, and read out, allowing for precise magnetic field measurements. The diamond-based quantum sensor may offer high sensitivity and may operate at room temperature, making it a promising choice for the MRI coil assembly.

According to one embodiment, the optical signal processing unit comprises a spectrometer for the digitization of the optical signal and a processing unit for creating the k-space data from the digitized signals. This may allow for the digitization of the optical signal, enabling further processing and analysis.

The spectrometer may be configured for converting the analog optical signal into a digital format. This conversion process may involve splitting the optical signal into different wavelengths and measuring their intensities. By capturing the spectral information, the spectrometer may enable precise digitization of the optical signal. In operation, the optical signal is received by the spectrometer, which may, for example, separate it into its constituent wavelengths using a diffraction grating or other suitable means. Each wavelength may then be detected by a photodetector, generating an electrical signal proportional to the intensity of that particular wavelength. These electrical signals may then be converted into digital form using an analog-to-digital converter, allowing for further processing and analysis. Furthermore, the optical signal processing unit may also include a processing unit. The processing unit is responsible for creating the k-space data from the digitized signals obtained from the spectrometer. K-space data may be a mathematical representation of the spatial frequency information contained within the optical signal. It may be a step in the reconstruction of the final image. The processing unit may utilize various algorithms and techniques to process the digitized signals and generate the k-space data. These algorithms may include Fourier transform-based methods, such as the fast Fourier transform (FFT), or other suitable techniques for extracting the spatial frequency information. The resulting k-space data may then be further processed to reconstruct the final image using image reconstruction algorithms. In one example, the optical signal processing unit may be located close, integrated with the quantum sensor in the MRI coil. In case of a coil array, a distributed processing unit or a local subunit may be realized.

According to one embodiment, the MRI coil assembly may be comprised in an MRI apparatus. The MRI apparatus may be configured to acquire MR image data from the object. The MRI apparatus may use strong magnetic fields, magnetic field gradients, and radio waves generated by the MR coil assembly to generate images of the object using the optical signals obtained by the MR coil assembly.

The MRI apparatus further comprises a magnet assembly configured to generate a magnetic field in an inner space of the magnet assembly, to be applied to the object. Furthermore, the MRI apparatus may include additional components, such as gradient coils, shim coils, or other auxiliary coils, to further enhance the imaging capabilities. This may enable to integrate the MRI coil assembly into the MRI apparatus in a manner that optimizes their functionality and interaction with other components of the MRI apparatus.

The magnet assembly may comprise a permanent magnet and/or superconducting electromagnet. Permanent magnets may be magnets that retain their magnetic properties without the need for an external power source, while electromagnets may use an electric current to generate a magnetic field. The choice between permanent magnets and electromagnets may depend on various factors such as cost, size, and desired magnetic field strength. The magnet assembly may also include magnetic shielding to minimize external interference and maintain the integrity of the magnetic field. Magnetic shielding can be achieved using materials with high magnetic permeability, such as ferromagnetic alloys or superconducting materials. These materials may redirect external magnetic fields away from the inner space of the magnet assembly, reducing distortions in the generated magnetic field. To ensure patient safety and comfort, the magnet assembly may be enclosed within a housing or gantry. The housing may provide structural support and prevent unauthorized access to the inner space of the magnet assembly. It may also include features such as patient positioning systems and imaging accessories to facilitate the imaging process.

In operation, the magnet assembly may generate a strong and uniform magnetic field (B0) within its inner space. This magnetic field interacts with the atomic nuclei of the object being imaged, aligning them in a specific orientation. By applying radiofrequency pulses and detecting the resulting signals, detailed images of the object's internal structures can be reconstructed.

The magnet assembly may have different field strengths depending on the imaging requirements. High-field MRI systems, typically operating at 1.5 Tesla or higher, may offer improved image resolution and signal-to-noise ratio. Low-field MRI systems, operating at field strengths below 1.5 Tesla, may be more cost-effective and suitable for certain imaging applications.

According to one embodiment, the optical signal processing unit is remotely located from the set of quantum sensors at a specific location such that a strength of the magnetic field of the MRI apparatus at the location is smaller than a magnetic field threshold and/or an acoustic noise level of the MRI apparatus at the location is smaller than a noise threshold.

This positioning may ensure that the strength of the magnetic field at the location of the optical signal processing unit remains below a predetermined magnetic field threshold. By keeping the magnetic field strength below this threshold, the integrity and functionality of the optical signal processing unit may be maintained. In addition to the magnetic field threshold, the specific location of the optical signal processing unit may also be chosen to minimize the acoustic noise level of the MRI apparatus. The acoustic noise level at this location is kept below a predetermined noise threshold. This may be important to ensure that the optical signal processing unit can operate effectively without being affected by excessive noise generated by the MRI apparatus.

In another aspect, the invention relates to a method for a magnetic resonance imaging, MRI, coil assembly, the MRI coil assembly comprising: a set of one or more quantum sensors and associated set of one or more radio frequency coils respectively; wherein each radio frequency coil of the set of one or more radio frequency coils is configured to perform radio frequency excitation in an object to be imaged for inducing a magnetic resonance signal from the object, the method comprising: receiving by each quantum sensor of the set of one or more quantum sensors a signal induced by the magnetic resonance signal in the respective radio frequency coil; providing by the quantum sensor an optical signal representing the MRI signal through an optical link; receiving by an optical processing unit through the optical links from the set of one or more quantum sensors the one or more optical signals; digitizing by the optical processing unit the one or more optical signals.

In another aspect, the invention relates to a computer program for a magnetic resonance imaging, MRI, coil assembly, the MRI coil assembly comprising: a set of one or more quantum sensors and associated set of one or more radio frequency coils respectively; wherein each radio frequency coil of the set of one or more radio frequency coils is configured to perform radio frequency excitation in an object to be imaged for inducing a magnetic resonance signal from the object, the computer program comprising machine executable instructions configured for causing a computational system to control the set of one or more quantum sensors and an optical processing unit to perform the method.

The present disclosure may provide another implementation of the quantum sensors for magnetic field mapping which is described in the following section "Magnetic field mapping based on quantum sensors".

### Magnetic field mapping based on quantum sensors

Embodiments may provide a hardware system consisting of a new generation of magnetic sensors, arranged in 3D in and around the MRI scanner, to build a non-interfering 3D magnetic field camera, operable during MRI scanner usage. An array of magnetometers can be used to measure the magnetic flux vector at various locations and model-based field interpolation with magnetostatic equations can deliver 3D B-field maps throughout the scanner, in real time during image acquisition. This gained information may be used for improved reconstruction, active shimming and gradient correction (due to fast optical signal transmission) for improved k-space data fidelity, and possibly active noise cancellation for shielding-free MRI. A check concerning metals and active components may be performed when the patient is approaching the scanner due to the high sensitivity of the magnetometers. Predictive maintenance may be boosted due to constant surveillance of field homogeneity and drifts, enabling automated warnings or counteractions. For the future autonomous scanner, such self-surveillance and real-time field quality assurance technology is crucial.

According to an aspect of the present disclosure, there is provided a first magnetic resonance imaging (MRI) component assembly. The first MRI component assembly is designed for mapping a main magnetic field B0 within an imaging region of the MRI apparatus. The first MRI component assembly comprises a set of quantum sensors. Each quantum sensor of the set of quantum sensors is configured for receiving a magnetic field signal at a location of the quantum sensor. The quantum sensor is also configured to provide an optical signal representing the magnetic field signal through a respective optical link.

According to an aspect of the present disclosure, there is provided an optical signal processing unit that is comprised in the first MRI component assembly. The optical signal processing unit is configured for receiving the optical signals from the set of quantum sensors through the optical links. Additionally, the optical signal processing unit is configured for using the optical signals to compute a magnetic flux at the location of each quantum sensor of the set of quantum sensors.

This example may offer real-time, absolute knowledge of the magnetic field throughout the scanner, including the B0 vector field and gradients. This may enable real-time shimming, gradient linearity correction, detection of patient motion, and predictive maintenance of the magnetic field by detecting field drift and alerting users or taking automatic counter-actions. The overall quality of B0 field may be improved due to continuous measurement of the field strength distribution and the opportunity to adjust currents to even out microscopic material variations, production flaws, patient impedance and susceptibility effects, and patient motion. This can be done in real-time during image acquisition due to direct optical signal transmission. This example may also potentially provide high-quality, 3D B0 maps during each scan to aid in image reconstruction. It may measure the 3-component vector magnetic flux B = (Bx, By, Bz) e.g., instead of just the magnitude |B| or z-component or Bz.

Each quantum sensor within the set may be specifically configured to receive a magnetic field signal at a precise location on the quantum sensor. This may allow for accurate mapping of the main magnetic field within the imaging region. The quantum sensors are designed to provide an optical signal that represents the received magnetic field signal. This optical signal is then transmitted through a respective optical link. The optical link may comprise one or more fiber optic cables or other suitable means of optical transmission. Furthermore, the optical links used to transmit the optical signals may vary in terms of their length, material, or transmission capabilities. The optical signals may be transmitted over long distances without significant loss or degradation, ensuring the accurate representation of the magnetic field information. The use of optical signals may allow for efficient and reliable transmission of the magnetic field information. The laser absorption spectrum of the optical signal may be analyzed to attain absolute field measurements at the sensor location.

With this example, installation may be easier and cheaper as no external field camera may need to be mounted and unmounted. The first MRI component assembly may be realized as a stand-alone product, with which one can equip existing scanners for real-time B0 maps and predictive maintenance, or the quantum sensors could be integrated with MRI scanners as a native B0 map and gradient fidelity surveillance and correction system.

In one example, the set quantum sensors may be three quantum sensors. Alternatively, the set of quantum sensors may be an array of more than three quantum sensors. Alternatively, the number of quantum sensors may be higher than a threshold, wherein the threshold is provided so that the magnetic field mapping may be performed using the set of quantum sensors. Each quantum sensor may be connected to the optical signal processing unit through a respective optical link. The optical link may comprise one or more fiber optic cables or other suitable means of optical transmission.

According to one example, the first MRI component assembly further comprises a mapping unit. The mapping unit is configured for receiving the magnetic fluxes from the optical processing unit. Additionally, the mapping unit is configured for creating a magnetic field map for the imaging region. The creation of the magnetic field map is achieved using the computed magnetic fluxes. The mapping unit may create a detailed magnetic field map that accurately represents the magnetic field strength and direction at various points within the imaging region. The magnetic field map may, for example, be a 3D magnetic field map.

By receiving the magnetic fluxes from the optical processing unit, the mapping unit may be able to generate a magnetic field map for the imaging region. This magnetic field map may be created by utilizing the computed magnetic fluxes obtained from the optical processing unit.

Furthermore, the mapping unit may be configured to provide real-time updates of the magnetic field map during the imaging process. This may allow for dynamic adjustments to be made based on changes in the magnetic field within the imaging region. For example, if there is a sudden shift in the magnetic field strength or direction, the mapping unit may quickly update the magnetic field map based on newly received optical signals to reflect these changes, ensuring accurate and reliable imaging results.

In one example, the mapping unit may employ algorithms and mathematical models to process the magnetic flux data in order to create the magnetic field map. These algorithms may take into account various factors such as the position and orientation of the magnetic field sources, as well as any external influences that may affect the magnetic field distribution. By accurately analyzing these factors, the mapping unit may generate a comprehensive magnetic field map that accurately represents the imaging region. For example, with knowledge of the magnetic flux B at the sensor locations, the mapping unit may use EM modelling equations to calculate the field at different locations within the scanner in 3D. At lower B0 field strengths, the flux approximation from the Maxwell/Biot-Savart equations may become increasingly precise.

According to one example, the mapping unit is remotely connected to the optical processing unit.

According to one example, the optical signal processing unit further comprises a spectrometer. The spectrometer is configured for the digitization of the optical signal. Additionally, the optical signal processing unit comprises a processing unit. The processing unit is configured for using the digitized signals. Specifically, the processing unit uses the digitized signals for the computing of the magnetic flux. In one example, the processing unit may comprise an ML model taking digitized signals as input to produce the magnetic field map.

According to one example, the first MRI component assembly comprises a quantum sensor. The quantum sensor is either an Optically pumped magnetometer (OPM) or a solid state spin defect-based quantum sensor.

The solid state spin defect-based quantum sensor may, for example, be a diamond-based quantum sensor.

One embodiment of the quantum sensor is the Optically pumped magnetometer (OPM). The OPM utilizes the principles of quantum physics to detect magnetic fields. It may consist of a vapor cell filled with alkali metal atoms, such as rubidium or cesium. These atoms are optically pumped using laser light, which aligns their spins in a specific direction. When a magnetic field is present, it causes a precession of the aligned spins, which can be detected by measuring the changes in the light absorption of the atoms. The OPM may offer excellent sensitivity and can operate at room temperature, making it a practical choice for the first MRI component assembly.

Another embodiment of the quantum sensor is the diamond-based quantum sensor. This type of sensor utilizes the unique properties of diamond, specifically the presence of nitrogen-vacancy (NV) centers. NV centers are defects in the diamond lattice where a nitrogen atom replaces a carbon atom, adjacent to a vacant lattice site. These NV centers have electronic spins that can be manipulated and measured to detect magnetic fields. By applying microwave and laser pulses, the NV centers can be initialized, manipulated, and read out, allowing for precise magnetic field measurements. The diamond-based quantum sensor may offer high sensitivity and can operate at room temperature, making it a promising choice for the first MRI component assembly.

According to one example, the optical signal processing unit comprises a trained machine learning, ML, model. The ML model is configured to receive the computed magnetic fluxes and predict a magnetic field map. Additionally, the optical signal processing unit is configured for creating the magnetic field map. This is achieved by inputting the computed magnetic fluxes to the ML model in order to obtain the magnetic field map.

The ML model may play a role in the magnetic field mapping process. The ML model is specifically designed to receive the computed magnetic fluxes and predict a magnetic field map based on this input. By utilizing the ML model, the optical signal processing unit may be able to create an accurate and detailed magnetic field map. To achieve this, the computed magnetic fluxes are inputted into the ML model, which then processes the data and generates the corresponding magnetic field map. This process may be automated and may eliminate the need for manual interpretation or analysis of the magnetic fluxes. The ML model has been trained on a vast amount of data, enabling it to accurately predict the magnetic field map based on the input it receives.

The ML model may, for example, be a deep neural network. The ML model may have been trained on a large dataset of magnetic fluxes and corresponding magnetic field maps, enabling it to accurately predict the magnetic field map based on the computed magnetic fluxes.

Alternatively, instead of utilizing a trained ML model, the optical signal processing unit may employ a rule-based algorithm to predict the magnetic field map based on the computed magnetic fluxes. This rule-based algorithm may utilize a set of predefined rules and logic to generate the magnetic field map, providing an alternative approach to the ML model.

According to one example, the first MRI component assembly further comprises a shimming system. The shimming system is configured to generate secondary magnetic fields. These secondary magnetic fields may be designed to counteract non-uniformities in the main magnetic field. The shimming system operates in accordance with shim settings. Furthermore, the shimming system is configured to adjust the shim settings according to the magnetic fluxes.

This may enable an accurate and fast adaptation of the shim coils based on the information of the quantum sensors that is transmitted fast on optical links.

According to one example, the optical signal processing unit is configured to repeatedly receive the optical signals and create the magnetic field map. Additionally, the shimming system is configured to repeatedly adjust the shim settings according to the currently created magnetic field map.

This may enable real-time adaptation of the shim coils based on the information of the quantum sensors. This may be beneficial for multi-slice or B0 sensitive 3D imaging scans (e.g., echo planar).

The shimming system may use the array of quantum sensors for dynamic calibration and correction of shim settings and adaptation of further parameters of the imaging sequence. An active feedback loop may be enabled for "real-time" gradient and B0 corrections by calculating needed adjustment and counter currents in the active shimming and gradient coils to actively improve field quality during scanning. This may be enabled by this invention due to high sensitivity field measurements and lightning-fast optical signal transmission with minimal need for conversion electronics (direct optical sensor readout).

The first MRI component assembly may further comprise an MRI apparatus, wherein the MRI apparatus is configured to acquire MR image data from the object. The MRI apparatus may use strong magnetic fields, magnetic field gradients, and radio waves to generate images of the object. The images may be generated using the magnetic fluxes obtained by the first MRI component assembly and/or the shim settings of the MRI apparatus may be adapted using the magnetic fluxes.

According to one example, the first MRI component assembly further comprises an MRI apparatus. The MRI apparatus is configured for receiving a request to acquire MRI data from an object in the imaging region. Additionally, the MRI apparatus comprises a magnet assembly. The magnet assembly is configured to generate the main magnetic field. Notably, the magnet assembly also comprises the shimming system. In the first MRI component assembly, the optical signal processing unit is configured to perform the computation of the magnetic fluxes in response to the request. Furthermore, the shimming system is configured to adjust the shim settings for the MRI data acquisition.

This example may be advantageous as the first MRI component assembly may be seamlessly integrated in existing MRI scanners. For example, the set of quantum sensors and the optical signal processing unit may be integrated easily in an existing MRI scanner. The quantum sensors may be small in size and the optical signal processing unit may be flexibly installed e.g., using adaptable lengths of the optical links.

The MRI apparatus may comprise a control unit. The control unit may be a computer or any other suitable device capable of processing and executing instructions. Upon receiving the request, the control unit communicates with the optical signal processing unit to initiate the computation of the magnetic fluxes. The optical signal processing unit is specifically designed to use currently received optical signals from the quantum sensors and perform the computation of the magnetic fluxes in response to the request for MRI data acquisition. It utilizes optical signal processing techniques to accurately calculate the magnetic fluxes within the imaging region. This may allow for precise mapping and visualization of the magnetic field distribution within the object being imaged. To ensure optimal image quality, the shimming system, also part of the first MRI component assembly, is configured to adjust the shim settings for the acquisition of the MRI data. The shimming system may utilize various techniques, such as gradient-based optimization algorithms or machine learning algorithms, to determine the optimal shim settings. These shim settings are then applied to the magnet assembly to fine-tune the main magnetic field, reducing any distortions or inhomogeneities that may affect the quality of the acquired MRI data.

The MRI apparatus may include additional components, such as a radiofrequency (RF) coil assembly. The RF coil assembly is designed to transmit and receive RF signals to and from the object being imaged. The control unit may also communicate with the RF coil assembly to coordinate the timing and synchronization of RF pulses during the MRI data acquisition process.

Furthermore, the shimming system may employ a feedback mechanism to continuously monitor and adjust the shim settings during the MRI data acquisition. This feedback mechanism may utilize real-time data from the optical signal processing unit to dynamically optimize the shim settings, ensuring consistent and high-quality MRI data acquisition.

According to one example, the set of quantum sensors is arranged in a cylindrical configuration. The cylindrical configuration is located within the MRI apparatus. Alternatively, the cylindrical configuration may be located within a patient table. The patient table is for the object, wherein the object is a patient.

These quantum sensors are arranged in a cylindrical configuration, which may allow for efficient and accurate detection of magnetic fluxes within the imaging region. The cylindrical configuration can be located within the MRI apparatus itself and/or within the patient table.

Alternatively, the cylindrical configuration of quantum sensors may be located within the patient table. In this configuration, the patient lies on the table, and the quantum sensors detect the magnetic fields in the imaging region. The optical signals from the quantum sensors are then processed by the optical signal processing unit, and the shimming system adjusts the shim settings accordingly.

In addition to the cylindrical configuration, other alternative configurations for the set of quantum sensors may be explored. For example, the quantum sensors may be arranged in a planar configuration, where they are placed in a flat surface within the MRI apparatus and/or patient table. This planar configuration may allow for a different perspective in detecting and measuring magnetic fields.

Furthermore, the number and arrangement of the quantum sensors may be varied to suit different imaging requirements. For instance, a higher number of quantum sensors distributed in a specific pattern may provide enhanced spatial resolution in the acquired MRI data. On the other hand, a lower number of quantum sensors arranged in a different pattern may be suitable for specific imaging applications where speed is prioritized over resolution.

According to one example, the set of quantum sensors is arranged in a cylindrical configuration. The cylindrical configuration is located within a bore of the MRI apparatus. Additionally, or alternatively, the cylindrical configuration may be located within an RF coil assembly of the MRI apparatus.

These quantum sensors are arranged in a cylindrical configuration, which may allow for efficient and accurate detection of magnetic fluxes. The cylindrical configuration is specifically chosen to fit within the bore of the MRI apparatus, ensuring that the quantum sensors are positioned close to the imaging region.

In an alternative example, the cylindrical configuration of the quantum sensors may be located within an RF coil assembly of the MRI apparatus. This arrangement may allow for simultaneous detection of both the magnetic fields and the radiofrequency signals used in the MRI imaging process. By integrating the quantum sensors within the RF coil assembly, the first MRI component assembly may provide enhanced sensitivity and spatial resolution in the acquired MRI data.

In addition to the cylindrical configuration within the bore and/or within the RF coil assembly, the first MRI component assembly may include other alternative arrangements of the quantum sensors. For example, the quantum sensors could be arranged in a planar configuration, allowing for imaging of flat objects or surfaces. Alternatively, the quantum sensors may be arranged in a three-dimensional array, enabling volumetric imaging of objects with complex shapes.

In one example, a 3D array of the quantum sensors may be arranged in a cylindrical configuration within the MRI apparatus, within the patient table and outside the bore. The quantum sensors with light fibre cabling may be installed within the bore for a system-native B0 mapping sensor system. An optical analyzer unit or Optical-to-Digital Converter (ODC) may be used to digitize the sensor signal and continue processing for a computation of the magnetic flux at each sensor. An algorithm for 3D field calculation from exact B-field knowledge at the sensor locations may be used. The 3D field calculation from the sensor set information can be facilitated by AI, e.g., by training a neural network with ground-truth field knowledge in experimental settings with well-known fields. The network could infer on the full field distribution from the sensor data directly, possibly incorporating patient interaction effects, if included in the training.

The present disclosure relating to magnetic field mapping may comprise the following clauses.

Clause 1.A magnetic resonance imaging, MRI, component assembly for mapping, a main magnetic field within an imaging region of a MRI apparatus, the MRI component assembly comprising: a set of quantum sensors, each quantum sensor of the set of quantum sensors being configured for receiving a magnetic field signal at a location of the quantum sensor and to provide an optical signal representing the magnetic field signal through a respective optical link; and an optical signal processing unit, the optical signal processing unit being configured for receiving the optical signals from the set of quantum sensors through the optical links, using the optical signals for computing a magnetic flux at the location of each quantum sensor of the set of quantum sensors.

Clause 2. The MRI component assembly of clause 1, further comprising a mapping unit, the mapping unit being configured for receiving the magnetic fluxes from the optical processing unit and creating a magnetic field map for the imaging region using the computed magnetic fluxes.

Clause 3. The MRI component assembly of clause 2, the mapping unit being remotely connected to the optical processing unit.

Clause 4. The MRI component assembly of any of the preceding clauses 1 to 3, the optical signal processing unit comprising a spectrometer for a digitization of the optical signal and a processing unit for using the digitized signals for the computing of the magnetic flux.

Clause 5. The MRI component assembly of any of the preceding clauses 1 to 4, the quantum sensor being an Optically pumped magnetometer (OPM) or a solid state spin defect-based quantum sensor.

Clause 6. The MRI component assembly of any of the preceding clauses 1 to 5, the optical signal processing unit comprising a trained machine learning, ML, model that is configured to receive the computed magnetic fluxes and predict a magnetic field map, the processing unit being configured for creating the magnetic field map by inputting the computed magnetic fluxes to the ML model in order to obtain the magnetic field map.

Clause 7. The MRI component assembly of any of the preceding clauses 1 to 6, further comprising a shimming system, the shimming system being configured, to generate secondary magnetic fields to counteract non-uniformities in the main magnetic field in accordance with shim settings, the shimming system being configured to adjust the shim settings according to the magnetic fluxes.

Clause 8. The MRI component assembly of clause 7, wherein the optical signal processing unit is configured to repeatedly receive the optical signals and create the magnetic field map, wherein the shimming system is configured to repeatedly adjust the shim settings according to the currently created magnetic field map.

Clause 9. The MRI component assembly of any of the preceding clauses 7 to 8, further comprising an MRI apparatus, the MRI apparatus being configured for receiving a request to acquire MRI data from an object in the imaging region, the MRI apparatus comprising a magnet assembly configured to generate the main magnetic field, the magnet assembly comprising the shimming system, wherein the optical signal processing unit is configured to perform the computation of the magnetic fluxes in response to the request, and the shimming system is configured to adjust the shim settings for the MRI data acquisition.

Clause 10. The MRI component assembly of clause 9, the set of quantum sensors being arranged in a cylindrical configuration within the MRI apparatus and/or within a patient table for the object being a patient.

Clause 11. The MRI component assembly of clause 9 or 10, the set of quantum sensors being arranged in the cylindrical configuration within a bore of the MRI apparatus and/or within an RF coil assembly of the MRI apparatus.

Clause 12. A method for mapping a main magnetic field within an imaging region of a MRI apparatus using a magnetic resonance imaging, MRI, component assembly, the MRI component assembly comprising a set of quantum sensors, the method comprising: receiving by each quantum sensor of the set of one or more quantum sensors a magnetic field signal at a location of the quantum sensor; providing by the quantum sensor an optical signal representing the magnetic field signal through an optical link; receiving by an optical processing unit through the optical links from the set of quantum sensors the optical signals; using by the optical processing unit the optical signals for computing a magnetic flux at the location of each quantum sensor of the set of quantum sensors.

Clause 13. A computer program for mapping a main magnetic field within an imaging region of a MRI apparatus using a magnetic resonance imaging, MRI, component assembly, the MRI component assembly comprising a set of quantum sensors, the computer program comprising machine executable instructions configured for causing a computational system to control the set of quantum sensors and an optical processing unit to perform the method of clause 12.

The present disclosure may provide another implementation of the quantum sensors for motion detection in MRI field which is described in the following section "MR-compatible motion detection based on electromagnetic field sensing".

### MR-compatible motion detection based on electromagnetic field sensing

Embodiments may provide a motion detection system, inherently MR-safe, ultrawide band with fast optical readout and signal transmission. Extremely sensitive electric and magnetic field sensors may be placed within the bore housing and patient table to monitor the fields generated by the patient in an MRI. Minor field changes associated with patient motion and breathing may be sensed directly in the patient bed and bore. The field sensors may be based on super-sensitive quantum detectors, a new generation of wide-band atomic field probes. As the sensors can detect even slight Doppler shifts, they can also be combined with electromagnetic transmitters (off-resonant to the MRI imaging band) to analyze the radiation backscattered by the patient for motion surveillance. This can become useful for retrospective motion correction in MRI reconstruction or triggered MRI acquisitions, as well as MRI automation and patient monitoring. There may also be predictive maintenance utilization by filtering high-frequency hardware vibrations and analyzing the spectrum for abnormalities in the background. Older MRI systems could be upgraded with such millimeter sized sensors using adhesive foils.

According to an aspect of the present disclosure, there is provided a second magnetic resonance imaging (MRI) component assembly. The second MRI component assembly is designed for the detection of a motion of a patient within an imaging region of an MRI apparatus. The second MRI component assembly comprises a set of quantum sensors. Each quantum sensor of the set of quantum sensors is configured for receiving a magnetic field signal and/or electric field signal at a location of the quantum sensor. The quantum sensor is also configured to provide, through a respective optical link, an optical signal representing the received signal. The second MRI component assembly comprises an optical signal processing unit. The optical signal processing unit is configured for receiving the optical signals from the set of quantum sensors through the optical links. Additionally, the optical signal processing unit is configured for processing the received optical signals. The processing of the received optical signals is for detecting a motion of the patient.

In one example, each quantum sensor of the set of quantum sensors is configured for receiving a magnetic field signal at a location of the quantum sensor. In one example, each quantum sensor of the set of quantum sensors is configured for receiving an electric field signal at a location of the quantum sensor. In one example, each quantum sensor of the set of quantum sensors is configured for receiving a magnetic field signal and electric field signal at a location of the quantum sensor.

The use of quantum sensors in the second MRI component assembly may offer several advantages. Firstly, the high sensitivity of these sensors may ensure that even subtle movements of the patient are accurately detected and measured. This may allow for improved image quality and diagnostic accuracy. Additionally, the optical links provide a reliable and efficient means of transmitting the detected signals. Optical signals may be less susceptible to interference and signal degradation compared to traditional electrical signals. This may ensure that the data captured by the quantum sensors is transmitted accurately and without loss.

The second MRI component assembly may be utilized in various medical imaging scenarios. For example, during a brain MRI, the quantum sensors may detect even the slightest head movements of the patient, ensuring that the images captured are precise and free from motion artifacts. Similarly, in a cardiac MRI, the assembly may monitor the patient's heartbeat and respiratory motion, enabling the imaging system to synchronize image acquisition with the patient's physiological state.

In one example, not only patient motion may be detected, but also hardware motion. Due to the high bandwidth of the quantum sensors, all relevant frequencies of mechanical vibrations induced in the hardware by the gradient coils may be detectable. Filtering the high frequency components of the quantum sensor signal may allow for automated supervision of hardware health in real time during patient scanning. This may be used for predictive maintenance purposes by, e.g., letting an artificial intelligence (AI) algorithm detect unusual behaviour or changes in the usually expected vibrational spectra during a scan, informing the operator of such events if possibly relevant for patient safety or image quality. The quantum sensors according to the present example may further be configured to improve the detection of the patient generated fields. For that, in one example, bandpass filtering to a frequency range for breathing, cardiac signal, and relatively low-frequency bulk motion of the patient may be used. I another example, machine learning may help to identify typical signatures of patient motion in the sensor signals.

The set of quantum sensors may be an array of quantum sensors. The number of quantum sensors may be higher than a threshold, wherein the threshold is provided so that the motion detection may be performed using the set of quantum sensors. Each quantum sensor may be connected to the optical signal processing unit through a respective optical link. The optical link may comprise one or more fiber optic cables or other suitable means of optical transmission.

According to one example, the second MRI component assembly further comprises a set of transmitters. The set of transmitters are configured for irradiating the patient with a low-energy electromagnetic radiation for inducing the magnetic field signal and/or the electric field signal.

The utilization of this low-energy electromagnetic radiation may serve to induce either the magnetic field signal, the electric field signal, or both.

For example, the set of transmitters may consist of a series of small coils strategically placed around the patient's body. These coils may be designed to emit a controlled and precise low-energy electromagnetic radiation. By doing so, they can generate a magnetic field signal that interacts with the patient's tissues and organs. For instance, when imaging the brain, the set of transmitters may emit a low-energy electromagnetic radiation that induces a magnetic field signal within the brain tissue. This magnetic field signal may then be detected and measured by the quantum sensors, allowing for the detection of the head motion.

Alternatively, the set of transmitters may also be utilized to induce an electric field signal within the patient's body. This can be particularly useful in certain medical procedures where targeted stimulation or modulation of specific tissues or nerves is desired. By emitting a low-energy electromagnetic radiation that generates an electric field signal, the set of transmitters may effectively influence the electrical activity within the patient's body.

Alternatively, the set of transmitters may be designed to emit low-energy electromagnetic radiation that induces both magnetic and electric field signals simultaneously. This may provide a more comprehensive and detailed understanding of the patient's anatomy and physiology.

Furthermore, alternative examples of the set of transmitters may be explored. For instance, instead of using coils, the transmitters may be implemented as arrays of microelectrodes or even optical devices that emit low-energy electromagnetic radiation. These alternative configurations may offer advantages in terms of spatial resolution, signal strength, or compatibility with specific patient populations.

According to one example, the optical signal processing unit comprises a spectrometer for a digitization of the optical signal and a processing unit for using the digitized signals for the detection of the motion of the patient.

The spectrometer may play a role in digitizing the optical signal. By converting the analog optical signal into a digital format, the spectrometer may enable more precise and accurate analysis of the signal. Furthermore, the processing unit is responsible for utilizing the digitized signals obtained from the spectrometer. Its function may be to detect and analyze the motion of the patient.

For example, if the second MRI component assembly is used to monitor the movement of a patient's limbs during a physical therapy session, the set of transmitters may emit low-energy electromagnetic radiation towards the patient's limbs. This radiation may induce magnetic and/or electric field signals in the limbs. The quantum sensors may detect these signals and provide optical signals. The optical signal processing unit may receive the optical signals generated. The spectrometer within the unit digitizes these optical signals, converting them into a digital format that can be easily processed. The processing unit then analyzes the digitized signals to detect any motion or changes in the position of the patient's limbs. This information may be used to track the progress of the therapy session, assess the effectiveness of certain exercises, or provide real-time feedback to the patient and therapist.

According to one example, the quantum sensor is an Optically pumped magnetometer (OPM) or a solid state spin defect -based quantum sensor. The solid state spin defect-based quantum sensor may, for example, be a diamond-based quantum sensor. This may provide high sensitivity and accuracy, allowing for precise imaging and diagnosis in MRI scans.

One embodiment of the quantum sensor is the Optically pumped magnetometer (OPM). The OPM utilizes the principles of quantum physics to detect magnetic fields. It may consist of a vapor cell filled with alkali metal atoms, such as rubidium or cesium. These atoms are optically pumped using laser light, which aligns their spins in a specific direction. When, for example, a magnetic field is present, it causes a precession of the aligned spins, which can be detected by measuring the changes in the light absorption of the atoms. The OPM may offer excellent sensitivity and can operate at room temperature, making it a practical choice for the second MRI component assembly.

Another embodiment of the quantum sensor is the diamond-based quantum sensor. This type of sensor utilizes the unique properties of diamond, specifically the presence of nitrogen-vacancy (NV) centers. NV centers are defects in the diamond lattice where a nitrogen atom replaces a carbon atom, adjacent to a vacant lattice site. These NV centers have electronic spins that can be manipulated and measured to detect, for example, magnetic fields. By applying microwave and laser pulses, the NV centers can be initialized, manipulated, and read out, allowing for precise magnetic field measurements. The diamond-based quantum sensor may offer high sensitivity and can operate at room temperature, making it a promising choice for the second MRI component assembly.

The second MRI component assembly may further comprise an MRI apparatus, wherein the MRI apparatus is configured to acquire MR image data from the object. The MRI apparatus may use strong magnetic fields, magnetic field gradients, and radio waves to generate images of the object. The images may be generated based on the detected motion by the second MRI component assembly.

According to one example, the second MRI component assembly further comprises an MRI apparatus. The MRI apparatus is configured to acquire MRI data from the patient in the imaging region, wherein the optical signal processing unit is configured to detect the motion of the patient during the MRI data acquisition.

The MRI apparatus may utilize a strong magnetic field and radio waves to generate detailed images of the patient's internal structures. This may allow for the visualization of anatomical features and the detection of abnormalities or diseases. The optical signal processing unit, which is an integral part of the second MRI component assembly, may be configured for detecting the motion of the patient during the MRI data acquisition process. This may be achieved by utilizing the quantum sensors that may be strategically placed around the imaging region. The optical signal processing unit may analyze the optical data received from the quantum sensors to determine the motion of the patient. The optical signal processing unit may employ algorithms and techniques to accurately track and measure any movement, such as breathing or involuntary muscle contractions, that may occur during MRI data acquisition. This information may then be used to compensate for the motion artifacts in the acquired MRI data, ensuring that the resulting images are clear and free from distortions caused by patient motion.

For example, the second MRI component assembly may be used in a different application, such as monitoring the respiratory motion of a patient during an MRI scan. In this case, the set of transmitters may emit low-energy electromagnetic radiation towards the patient's chest area. The resulting magnetic and/or electric field signals may be captured by the quantum sensors and the resulting optical signals may be digitized by the optical signal processing unit.
The processing unit may then analyze the digitized signals to detect any motion or changes in the patient's breathing pattern. This information may be used to synchronize the MRI scan with the patient's respiratory cycle, ensuring optimal image quality and reducing motion artifacts.

In another example, a patient is undergoing an MRI scan to assess the condition of their knee joint. The MRI apparatus acquires a series of images of the knee joint, capturing the internal structures in high detail. Concurrently, the optical signal processing unit may detect a motion of the patient's leg during the scan. If the patient moves their leg slightly due to discomfort or involuntary muscle contractions, the optical signal processing unit may compensate for this motion by adjusting the acquired MRI data. As a result, the final images of the knee joint may be free from blurring or distortions caused by the patient's movement, providing accurate information for diagnosis and treatment planning.

In an alternative example, the second MRI component assembly may utilize other types of motion detection technologies in addition to quantum sensors. For example, it may incorporate pressure sensors or accelerometers that are placed on the patient's body or cameras to detect motion. These other detection means may measure changes in pressure or acceleration caused by patient movement and transmit the data to the optical signal processing unit for analysis. The optical signal processing unit may then use this information in combination with the information acquired from the optical signals to detect motion. Additionally, the optical signal processing unit may compensate for motion artifacts in the acquired MRI data, ensuring high-quality images.

Another alternative example may involve the use of a combination of quantum sensors and motion tracking software. The quantum sensors may enable to capture the patient's movement, while the motion tracking software may analyze the data and provide real-time feedback to the MRI apparatus. This feedback may be used to adjust the scanning parameters or trigger an alert if excessive motion is detected, allowing for immediate corrective action.

According to one example, the optical signal processing unit is configured for processing the received optical signals by at least: digitizing the optical signals, inputting the digitized optical signals to a trained ML model, receiving from the ML model bulk motion parameters, the bulk motion parameters representing field changes in the digitized optical signals, and using the bulk motion parameters for the motion detection.

The ML model may enable an accurate detection of the patient motion.

For example, the ML model may have been trained to recognize patterns associated with motion artifacts. The ML model may process the digitized optical signals and generate bulk motion parameters that represent the detected field changes. Once the bulk motion parameters are received by the optical signal processing unit, a motion detection algorithm may be activated. This algorithm may compare the bulk motion parameters to predefined thresholds or reference values to determine if motion artifacts are present. If the algorithm detects that the field changes exceed the specified thresholds, it may identify the presence of motion artifacts. The motion detection algorithm within the optical signal processing unit may be implemented using various techniques. For example, it may utilize statistical analysis methods to compare the bulk motion parameters to a statistical model of expected motion artifacts. Alternatively, it may employ machine learning algorithms to classify the bulk motion parameters as either indicative of motion artifacts or not.

In another example, different ML models or motion detection algorithms may be employed, or additional signal processing techniques may be incorporated to improve the accuracy and efficiency of motion artifact detection.

According to one example, the bulk motion parameters are provided as a 3D patient surface representation of the patient. The optical signal processing unit is configured for the detection of the motion by at least calculating, using the 3D patient surface, a 3D motion vector field. The 3D motion vector field may be used for detecting the motion of the patient.

Using the 3D patient surface representation obtained from the bulk motion parameters, the 3D motion vector field may be computed. This motion vector field may represent the direction and magnitude of the patient's motion at different points on the patient's body. The computation may be performed by utilizing algorithms and mathematical models to accurately determine the motion vector field based on the 3D surface. The computed 3D motion vector field may be used to detect any motion exhibited by the patient during the MRI procedure. By comparing the motion vector field with predefined thresholds or reference values, one can identify and flag any significant motion that may impact the quality of the imaging results.

In another example, instead of relying solely on the 3D patient surface, the assembly may incorporate additional data sources. These sources may include data from other imaging modalities, such as ultrasound or infrared cameras, which can provide complementary information about the patient's motion. Furthermore, the assembly may employ different algorithms or mathematical models to compute the 3D motion vector field. These algorithms may be tailored to specific types of motion or patient populations, allowing for more accurate and personalized motion detection.

According to one example, the set of quantum sensors are arranged in a cylindrical configuration within the MRI apparatus and/or within a patient table that receives the patient.

This arrangement may allow for efficient and accurate detection of motion during the imaging process. The cylindrical configuration may be positioned strategically to capture motion data from various angles and perspectives.

Alternatively, or in addition to the arrangement within the MRI apparatus, the cylindrical configuration of quantum sensors may be located within a patient table. The patient table may be specifically designed to receive the patient during the MRI procedure. By integrating the quantum sensors within the patient table, motion detection may be performed directly on the patient's body, providing real-time feedback on any movement that may affect the imaging quality.

The quantum sensors within the cylindrical configuration may be capable of detecting optical signals emitted by the patient's body. These optical signals are processed by the optical signal processing unit, which is part of the second MRI component assembly. The optical signal processing unit is specifically configured to analyze and interpret the detected motion signals.

In addition to the cylindrical configuration of quantum sensors, other alternative examples may be implemented. For instance, the quantum sensors may be arranged in a planar configuration, covering a larger surface area to capture motion data from different regions of the patient's body simultaneously. Alternatively, the quantum sensors may be integrated into wearable devices, such as motion-tracking bands or garments, allowing for continuous monitoring of the patient's motion throughout the MRI procedure.

According to one example, the set of quantum sensors are arranged in the cylindrical configuration within a bore of the MRI apparatus and/or within an RF coil assembly of the MRI apparatus.

This arrangement may allow for efficient and accurate detection of motion within the patient. The cylindrical configuration may ensure that the quantum sensors are evenly distributed around the patient, providing comprehensive coverage of the patient's motion. The quantum sensors themselves are configured to detect optical signals related to the motion of the patient. These sensors may be highly sensitive and capable of capturing even subtle movements.

According to one example, the low-energy electromagnetic radiation is provided in the form of an electromagnetic signal having a wavelength in a millimetre-centimetre, mm-cm, wavelength range.

This electromagnetic signal has a wavelength within the millimetre-centimetre (mm-cm) range. The specific wavelength within this range may vary depending on the desired application and imaging requirements. For example, the second MRI component assembly may be designed to provide adjustable wavelength settings. This may allow for flexibility in conducting various types of analyses.

According to one example, the optical signal processing unit is remotely located from the set of quantum sensors at a specific location such that a strength of the magnetic field of the MRI apparatus at the location is smaller than a magnetic field threshold and/or an acoustic noise level of the MRI apparatus at the location is smaller than a noise threshold.

This positioning may ensure that the strength of the magnetic field at the location of the optical signal processing unit remains below a predetermined magnetic field threshold. By keeping the magnetic field strength below this threshold, the integrity and functionality of the optical signal processing unit can be maintained. In addition to the magnetic field threshold, the specific location of the optical signal processing unit may also be chosen to minimize the acoustic noise level of the MRI apparatus. The acoustic noise level at this location is kept below a predetermined noise threshold. This may be important to ensure that the optical signal processing unit can operate effectively without being affected by excessive noise generated by the MRI apparatus.

According to one example, the second MRI component assembly further comprises an acquisition and reconstruction control unit. The acquisition and reconstruction control unit is configured for adapting acquisition parameters of the MRI apparatus based on the detected motion and/or reconstructing MR image data based on the detected motion.

This acquisition and reconstruction control unit may be designed to adapt the acquisition parameters of the MRI apparatus based on the detected motion. By continuously monitoring the motion of the object being scanned, the acquisition and reconstruction control unit may dynamically adjust the imaging parameters to optimize image quality. The adaptation of acquisition parameters may take into account various factors such as the speed and direction of motion, as well as the specific region of interest being imaged. For example, if the subject is moving rapidly, the acquisition and reconstruction control unit may increase the repetition time (TR) to allow for more time between successive image acquisitions. This adjustment may help to reduce motion artifacts and improve image clarity.

Furthermore, the acquisition and reconstruction control unit may also be responsible for reconstructing the MR image data. This reconstruction process may take into consideration the detected motion to ensure accurate alignment and registration of the acquired data. By incorporating the motion information into the reconstruction algorithm, the acquisition and reconstruction control unit may compensate for any motion-related distortions or blurring that may occur during the imaging process.

According to one example, the acquisition and reconstruction control unit is remotely connected to the optical signal processing unit.

The present disclosure relating to motion detection may comprise the following features.

Feature 1. A magnetic resonance imaging, MRI, component assembly for detection of a motion of a patient within an imaging region of an MRI apparatus, the MRI component assembly comprising: a set of quantum sensors, each quantum sensor of the set of quantum sensors being configured for receiving a magnetic field signal and/or electric field signal at a location of the quantum sensor and to provide through a respective optical link an optical signal representing the received signal; and an optical signal processing unit, the optical signal processing unit being configured for receiving the optical signals from the set of quantum sensors through the optical links and processing the received optical signals for detecting a motion of the patient.

Feature 2. The MRI component assembly of feature 1, further comprising a set of transmitters, the set of transmitters being configured for irradiating the patient with a low-energy electromagnetic radiation for inducing the magnetic field signal and/or the electric field signal.

Feature 3. The MRI component assembly of any of the preceding features 1 to 2, the optical signal processing unit comprising a spectrometer for a digitization of the optical signal and a processing unit for using the digitized signals for the detection of the motion of the patient.

Feature 4. The MRI component assembly of any of the preceding features 1 to 3, the quantum sensor being an Optically pumped magnetometer (OPM) or a solid state spin defect-based quantum sensor.

Feature 5. The MRI component assembly of any of the preceding features 1 to 4, further comprising an MRI apparatus, the MRI apparatus being configured to acquire MRI data from the patient in the imaging region, wherein the optical signal processing unit is configured to detect the motion of the patient during the MRI data acquisition.

Feature 6. The MRI component assembly of any of the preceding features 1 to 5, the optical signal processing unit being configured for processing the received optical signals comprising: digitizing the optical signals, inputting the digitized optical signals to a trained ML model, receiving from the ML model bulk motion parameters, the bulk motion parameters representing field changes in the digitized optical signals, and using the bulk motion parameters for the motion detection.

Feature 7. The MRI component assembly of feature 6, the bulk motion parameters being provided as a 3D patient surface representation of the patient, the optical signal processing unit being configured for the detection of the motion comprising: calculating, using the 3D patient surface as the bulk motion parameters, a 3D motion vector field; using the 3D motion vector field for detecting the motion of the patient.

Feature 8. The MRI component assembly of feature 7, the set of quantum sensors being arranged in a cylindrical configuration within the MRI apparatus and/or within a patient table that receives the patient.

Feature 9. The MRI component assembly of feature 7 or 8, the set of quantum sensors being arranged in the cylindrical configuration within a bore of the MRI apparatus and/or within an RF coil assembly of the MRI apparatus.

Feature 10. The MRI component assembly of any of the preceding features 2 to 9, the low-energy electromagnetic radiation being provided in the form of an electromagnetic signal having a wavelength in a millimetre-centimetre, mm-cm, wavelength range.

Feature 11. The MRI component assembly of any of the preceding features 5 to 10, wherein the optical signal processing unit is remotely located from the set of quantum sensors at a specific location such that a strength of the magnetic field of the MRI apparatus at the location is smaller than a magnetic field threshold and/or an acoustic noise level of the MRI apparatus at the location is smaller than a noise threshold.

Feature 12. The MRI component assembly of any of the preceding features 5 to 11, further comprising an acquisition and reconstruction control unit configured for adapting acquisition parameters of the MRI apparatus based on the detected motion and/or reconstructing MR image data based on the detected motion.

Feature 13. The MRI component assembly of feature 12, the acquisition and reconstruction control unit being remotely connected to the optical signal processing unit.

Feature 14. A method for detection of a motion of a patient within an imaging region of an MRI apparatus using a magnetic resonance imaging, MRI, component assembly, the MRI component assembly comprising a set of quantum sensors, the method comprising: receiving by each quantum sensor of the set of one or more quantum sensors a magnetic field signal and/or electric field signal at a location of the quantum sensor; providing by the quantum sensor an optical signal representing the received signal through an optical link; receiving by an optical processing unit through the optical links from the set of quantum sensors the optical signals; processing by the optical processing unit the optical signals for detecting a motion of the patient.

Feature 15. A computer program for detection of a motion of a patient within an imaging region of an MRI apparatus using a magnetic resonance imaging, MRI, component assembly, the MRI component assembly comprising a set of quantum sensors, the computer program comprising machine executable instructions configured for causing a computational system to control the set of quantum sensors and an optical processing unit to perform the method of feature 14.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance image or MR image is defined herein as being the reconstructed two- or three-dimensional visualization of anatomic data contained within the k-space data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a magnetic resonance apparatus according to the disclosure.
Fig. 2 illustrates examples of quantum sensor arrangements for MRI signal reception in accordance with the present subject matter;
Fig. 3 illustrates an example quantum sensor arrangement for MRI signal reception in accordance with the present subject matter;
Fig. 4 shows a flowchart of a method for MRI signal reception;
Fig. 5 illustrates examples of quantum sensor arrangements 501, 511 and 521 for magnetic field mapping in accordance with the present subject matter;
Fig. 6 is a flowchart of a method for magnetic field mapping;
Fig. 7 illustrates examples of quantum sensor arrangements for motion detection in accordance with the present subject matter;
Fig. 8 is a flowchart of a method for motion detection.

### DETAILED DESCRIPTION OF EMBODIMENTS

Like numbered elements in these figures are either equivalent elements or perform the same function. Elements which have been discussed previously will not necessarily be discussed in later figures if the function is equivalent.

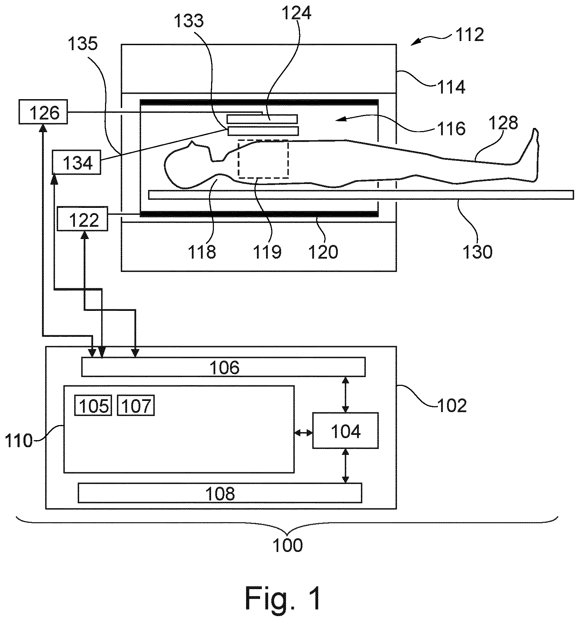

Fig. 1 illustrates an example of a medical system 100. The medical system 100 comprises a magnetic resonance imaging apparatus 112. The magnetic resonance imaging apparatus 112 may be controlled by a computational system 104.

The magnetic resonance imaging apparatus 112 comprises a magnet 114. The magnet 114 is a superconducting cylindrical type magnet with a bore 116 through it. The use of different types of magnets is also possible; for instance, it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 116 of the cylindrical magnet 114 there is an imaging region or zone 118 where the magnetic field may be strong and uniform enough to perform magnetic resonance imaging. A field of view 119 is shown within the imaging region 118. The k-space data that is acquired is typically acquired for the field of view 119. The region of interest could be identical with the field of view 119 or it could be a sub volume of the field of view 119. A subject 128 is shown as being supported by a subject support (or patient table) 130 such that at least a portion of the subject 128 is within the imaging region 118 and the field of view 119.

Within the bore 116 of the magnet there is also a set of magnetic field gradient coils 120 which is used for acquisition of preliminary k-space data to spatially encode magnetic spins within the imaging region 118 of the magnet 114. The magnetic field gradient coils 120 are connected to a magnetic field gradient coil power supply 122. The magnetic field gradient coils 120 are intended to be representative. Typically, magnetic field gradient coils 120 contain three separate sets of coils for spatial encoding in three orthogonal spatial directions. A magnetic field gradient power supply supplies current to the magnetic field gradient coils. The current supplied to the magnetic field gradient coils 120 is controlled as a function of time and may be ramped or pulsed.

Adjacent to the imaging region 118 is a radiofrequency coil system 124 for manipulating the orientations of magnetic spins within the imaging region 118 and for receiving radio transmissions from spins also within the imaging region 118. The radiofrequency antenna may contain multiple coil elements. The radiofrequency antenna may also be referred to as a channel or antenna. The radiofrequency coil system 124 may be optionally connected to a radiofrequency transceiver 126. The radiofrequency coil system 124 and radiofrequency transceiver 126 may be replaced by separate transmit and receive coils and a separate transmitter and receiver. It is understood that the radiofrequency coil system 124 and the radiofrequency transceiver 126 are representative. The radiofrequency coil system 124 is intended to also represent a dedicated transmit antenna and a dedicated receive antenna. Likewise, the transceiver 126 may also represent a separate transmitter and receivers. The radiofrequency coil system 124 may also have multiple receive/transmit elements and the radiofrequency transceiver 126 may have multiple receive/transmit channels. The radiofrequency coil system 124 may comprise a set of one or more radio frequency coils.

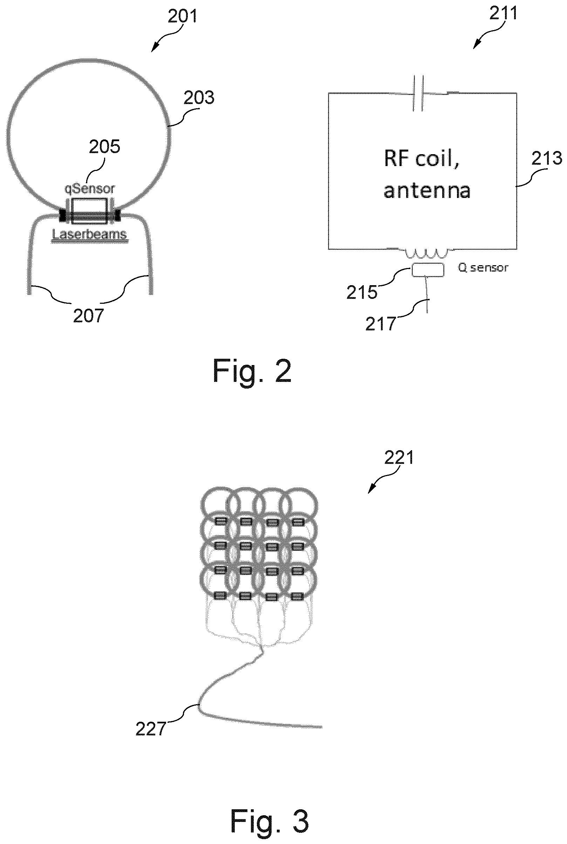

The magnetic resonance imaging apparatus 112 further comprises a set of quantum sensors 133. The set of quantum sensors 133 may be connected to an optical signal processing unit 134 through fibre optical links 135. The set of quantum sensors 133 may be arranged within the magnetic resonance imaging apparatus 112 in accordance with a quantum sensor arrangement. The quantum sensor arrangement may be defined depending on the desired application and requirements of the MRI apparatus 112. Figs. 2, 3, 5 and 7 provide examples of quantum sensor arrangements.

The optical signal processing unit 134, the transceiver 126 and the gradient controller 122 are shown as being connected to the hardware interface 106 of the computer system 102 to exchange data and commands.

The computer 102 is intended to represent one or more computers or computer systems. The computational system 104 is intended to represent one or more computational systems or computational cores. The computer 102 is further shown as containing the hardware interface 106 which is connected to the computational system 104. The computer 102 is further shown as comprising an optional user interface 108 which may provide various means for relaying data and receiving data and commands from an operator.

The computer 102 is further shown as comprising a memory 110 that is connected to the computational system 104. The memory 110 is intended to represent various types of memory which may be accessible to the computational system 104. The memory 110 is shown as containing machine-executable instructions 107. The machine-executable instructions 107 are instructions which enable the computational system 104 to perform various control, data processing, and image processing tasks. The memory 110 is further shown as containing k-space data 109 that have been acquired for imaging a volume of a subject.

The memory 110 is further shown as containing pulse sequence commands 105. The pulse sequence commands 105 are commands or data which can be converted into commands which enable the computational system 104 to control the magnetic resonance imaging apparatus 112 to acquire k-space data 109. The memory 110 shows the k-space data 109 that has been acquired by controlling the magnetic resonance imaging apparatus 112 with the pulse sequence commands 105.

Fig. 2 illustrates examples of quantum sensor arrangements 201 and 211 for MRI signal reception in accordance with the present subject matter.

The quantum sensor arrangement 201 comprises a quantum sensor 205 and associated RF coil 203. The quantum sensor 205 is placed inside a capacitor of the RF coil 203 in order to receive an electric field signal. For obtaining the RF coil 203, for example, a copper wire may be wound to an LC-circuit, resonating at the Larmor frequency. Inside the capacitor, the quantum sensor 205 is placed and operated with laser light as indicated in Fig. 2. The optical signal may be extracted through light fibre cables 207 to a spectrometer for processing and digitization for a spectrum analysis. This quantum sensor arrangement 201 may provide a hybrid solution for MRI signal reception because it combines the RF coil 203 with the quantum sensor 205.

In operation, the circularly polarized EM radiation emitted by a subject induces an AC current in the conducting coil 203. This may optimally focus the circularly polarized RF radiation from the precessing sample magnetization to a linearly polarized, spatially concentrated electric field oscillation between the capacitor plates. In the capacitor gap, where the quantum sensor 205 is placed, the linearly polarized E-field oscillates driven by the induced coil currents, and thus may be concentrated to a tiny space to amplify intensity at the quantum sensor 205. For example, with NV diamond sensors, it may be beneficial to attach an antenna to the diamond with a very small conductive junction at the sensor 205, which also creates strong electric fields locally. The quantum sensor 205 may be read out with laser light, which may allow the optical signal to be guided out directly without conversion/digitization electronics or pre-amplifiers in the bore of the MRI apparatus. The laser transmission rates, highly dependent on local E- and B-fields, may be analyzed elsewhere without hardware MR-safety constraints to get real-time radiative field information (transmitted at light speed) at a huge bandwidth. The optical signal may be digitized near a spectrometer, far away from the patient and B0 e.g., inside the base of the patient table.

Hence, the quantum sensor arrangement 201 may enable converting the induced electric signal in the coil 203 to an optical signal using the quantum sensor 203, instead of amplifying and digitizing the analogue electric signal from the coil directly. The coil 203 may function more as a waveguide/transformer analogy and the actual signal detection may be shifted to the precise measurement of concentrated electric and/or magnetic fields, focused in certain, small regions by the coil geometry. For example, this quantum sensor arrangement 201 may be obtained from an existing RF coil assembly by, for example, keeping a round coil winding but replacing the pre-amplifier with the quantum sensor 205 to directly convert to an optical signal. For example, with this quantum sensor arrangement 201, the RF field energy may be focused to an electric field inside the capacitor using a waveguide similar to a classic pickup coil, by placing the quantum sensor 205 inside the capacitor gap and retrieving the optical signal directly from a sensor laser with optic fibre cables. This may replace the pre-amplifier e.g., used in "dStream" coils, and yield direct optical signal with high bandwidth and transmission speed, and low noise, while also reducing the amount of potentially EM-non-transparent and noise contributing copper wiring and total weight and volume of the pickup equipment.

The quantum sensor arrangement 211 comprises a quantum sensor 215 and associated RF coil 213. The quantum sensor arrangement 211 may provide an alternative hybrid solution.

The quantum sensor 215 may be placed inside or beside the RF coil 213 instead of a capacitor to measure the induced magnetic flux locally inside the coil 213. In this arrangement 211, the circularly polarized RF radiation from the subject in the scanner may be converted to a linearly polarized magnetic field oscillation inside the coil 213, serially connected (or part of) the RF coil antenna. The RF coil inspired loop antenna is depicted by a rectangle. The capacitor end is at the top and at the bottom, and a small coil has been added serially within the loop. The quantum sensor 215 may be placed inside or beside the coil to detect the concentrated magnetic flux generated by the small coil. The quantum sensor optical readout is fed to the spectrometer for analysis in a similar way as described with the arrangement 201. In particular, the optical signal may be extracted through light fibre cables 217 to a spectrometer for processing and digitization for a spectrum analysis. In this example, the coil may function as a magnetic flux generator locally, concentrating the magnetic field generated by the induced RF fields of the magnetic spins of the sample. By exploiting the coherent interaction between the quantum sensor and RF field, quantum enhanced MRI detection may thus be realized.

Fig. 3 illustrates an example quantum sensor arrangement 301 for MRI signal reception in accordance with the present subject matter. The quantum sensor arrangement 301 comprises an array of RF coils and associated quantum sensors respectively. The quantum sensor arrangement 301 may be obtained as an array of individual quantum sensor arrangements, wherein each individual quantum sensor arrangement may be the quantum sensor arrangement 201 or the quantum sensor arrangement 211 as described with reference to Fig. 2. In this example of Fig. 3, a schematic depiction of a 16-channel pickup array designed similar to classic phased arrays (e.g., including decoupling overlap or detuning mechanism), but with optic fibre signal extraction and boosted SNR due to increased sensitivity and absence of pre-amplifiers. The optical signals may be extracted through light fibre cables 227 to a spectrometer for processing and digitization for a spectrum analysis.

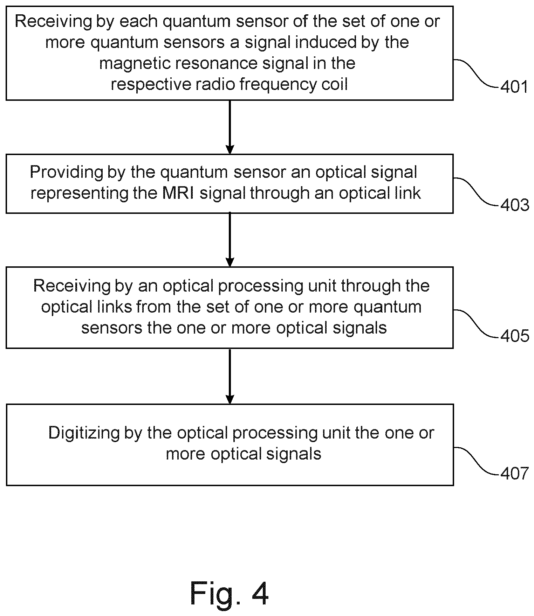

Fig. 4 is a flowchart of a method for MRI signal reception. For the purpose of explanation, the method described in Fig. 4 may be implemented in the system illustrated in Fig. 1, but is not limited to this implementation. Each radio frequency coil of a set of one or more radio frequency coils is configured to perform radio frequency excitation in an object to be imaged for inducing a magnetic resonance signal from the object.

Each quantum sensor of the set of one or more quantum sensors may receive in step 401 a signal induced by the magnetic resonance signal in the respective radio frequency coil. Each quantum sensor may provide or output in step 403 an optical signal representing the MRI signal through an optical link 135. An optical processing unit 134 may receive in step 405 through the optical links 135 from the set of one or more quantum sensors the one or more optical signals. The optical processing unit may digitize in step 407 the one or more optical signals.

One example application of the method of Fig. 4 may be the classic macroscopic MRI (e.g., current medical applications), where these quantum sensors may propel imaging into new SNR realms. Furthermore, the quantum sensors may enable more energy-efficient, super sensitive MRI, working with weaker fields because SNR is of another level. For industry applications of MRI, the quantum sensors may enable new material analysis methodology. With one pickup unit, different nuclei, field strengths, and even nuclear and electron magnetic resonance may be facilitated. This may greatly simplify MRI-related equipment and workflow. The quantum sensor arrangements may enable sharing of coils between different systems, which may save resources. They may be used, for example, to build fast ramp-able MRI systems operating at different field strengths, ramping/modulating the B0 field during acquisition, and possibly enabling new imaging methods to develop. This may even become an extra contrast dimension in conventional MRI, which can be used to interrogate microscopic susceptibility influences in tissue (e.g., blood oxygenation mapping based on deoxy-haemoglobin concentration in blood capillaries, cf. BOLD effect). Static field modulation could bring forth methods to replace intravenous contrast agents, since they both leverage similar effects concerning the body's paramagnetic answer to an external field application.

Due to the calibration-less absolute field measurements attainable from quantum sensors (like nitrogen-vacancy diamonds or alkali metal gas cell sensors), and their ability to determine the location of a radiating source and Doppler shifts, as well as measuring the 3-component vector magnetic flux B = (Bx, By, Bz), instead of just the magnitude |B| or z-component or Bz, new ways of using MRI or the development of entirely new imaging methods may follow adoption. This may also yield new possibilities for magnetic particle imaging (MPI) and other particle tracing techniques. Ultimately, this may also improve the energy consumption of MRI and related imaging systems, because much weaker fields could be detected and field strengths could be reduced. Because optical signal transmission is already being used in dStream coils, patient tables are already equipped with optical connectors today, the new quantum coils could integrate well with current and older MRI scanners.

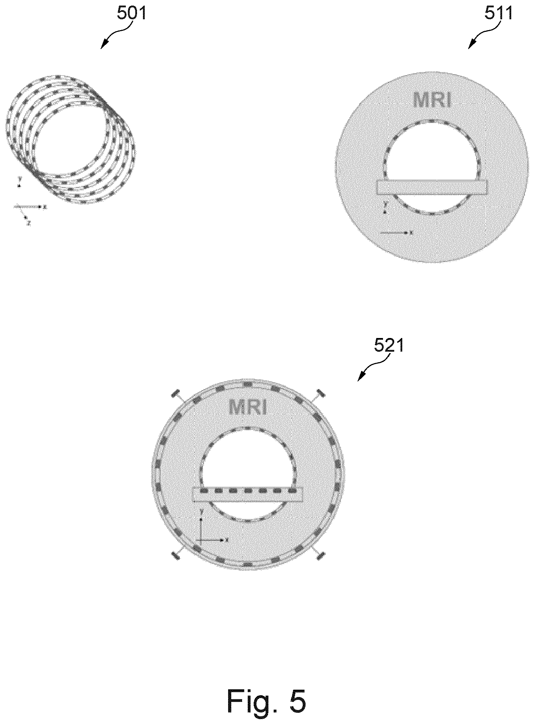

Fig. 5 illustrates examples of quantum sensor arrangements 501, 511 and 521 for magnetic field mapping in accordance with the present subject matter.

Each of the quantum sensor arrangements 501, 511 and 521 consists of a set of quantum sensors, which directly provide an optical signal, which can be collected from the quantum sensors through optic fibre cables. This may provide MR-neutral sensors without danger of introducing conducting wires into the scanning room that may become antennae and amplify colored RF noise, which may be detrimental to image quality and fidelity. The laser absorption spectrum of the optical signal may be analyzed to attain absolute field measurements at the sensor location.

A 3D array of such quantum sensors may be arranged, e.g., in a cylindrical configuration within the scanner, within the patient table and outside the bore. The MR-neutral sensors with light fibre cabling may be installed within the scanner bore for a system-native B0 mapping sensor system. With knowledge of the magnetic flux B at the sensor locations, EM modelling equations may be used to calculate the field at every location within the MRI apparatus in 3D. At lower B0 field strengths, the flux approximation from the Maxwell/Biot-Savart equations may become increasingly precise.

In the quantum sensor arrangement 501, the quantum sensors (with µm-mm size) shown as small black rectangles may be arranged as an array of rings in the x-y-plane and stacked for a cylindrical coverage along the z-axis (patient bore axis).

As shown with an x-y-view of the MRI apparatus, in the quantum sensor arrangement 511, the quantum sensors are shown as small black rectangles within the MRI apparatus and are provided as a quantum sensor ring construction within the bore, e.g., just underneath the plastic cover, of the MRI apparatus.

As shown with the x-y-view of the MRI apparatus, in the quantum sensor arrangement 521, quantum sensors, shown as small black rectangles within the MRI apparatus, provide a 3D coverage around the patient and are placed, e.g., in the patient bed, around the outside of the MRI bore. The quantum sensors may also be placed on pickup coil equipment (e.g., head coil) for additional field information. For model-based field interpolation using Maxwell equations, all additional anker points of measurement may be helpful.

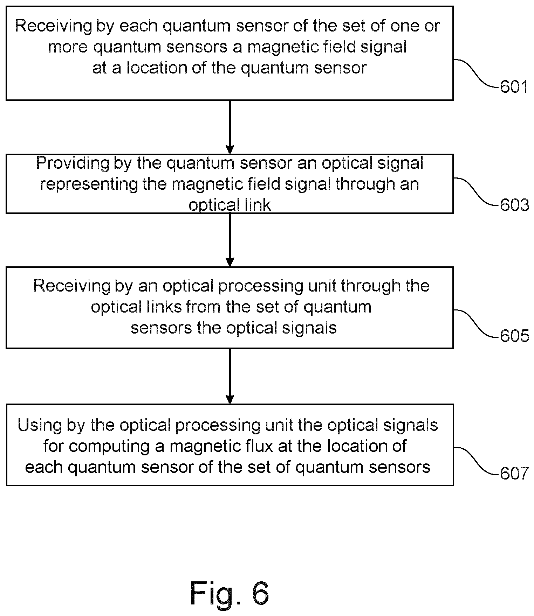

Fig. 6 is a flowchart of a method for magnetic field mapping. For the purpose of explanation, the method described in Fig. 6 may be implemented in the system illustrated in Fig. 1, but is not limited to this implementation.

Each quantum sensor of the set of quantum sensors may receive in step 601 a magnetic resonance signal at a location of the quantum sensor. Each quantum sensor may provide or output in step 603 an optical signal representing the magnetic field signal through an optical link 135. An optical processing unit 134 may receive in step 605 through the optical links 135 from the set quantum sensors the optical signals. The optical processing unit may use in step 607 the optical signals for computing a magnetic flux at the location of
each quantum sensor of the set of quantum sensors.

One example application of the method of Fig. 6 may be at lower field strengths (e.g., B0 = 0.6 Tesla or less), where the obtained 3D magnetic field predictions using the Maxwell/Biot-Savart equations may be increasingly accurate, because patient interactions with the field, in terms of electric impedance and unwanted waveguiding effects, decrease dramatically due to the longer wavelength RF radiation and weaker fields and electromotive forces involved. Thus, a combination with low-field MRI may be used, possibly enabling inhomogeneous field imaging and a MRI scanner that could work with an inhomogeneous B0. A loosening of the B0 homogeneity condition could dramatically lower production costs of MR scanners and may birth a new MRI "value segment" with cheap-to-produce-and-maintain, permanent magnet B0 scanners.

The exact field knowledge from this disclosure could be used with special reconstruction algorithms, incorporating this information, possibly learned directly with artificial intelligence (AI). In addition, image quality improvements may be expected by incorporating the obtained B0-map information into reconstruction, and also from the active field correction that is enabled. For example, a patient breathing signal and motion detection may be extracted from the time-resolved field monitoring as well, aiding motion sensitive sequences. In addition, this mapping of B0 field may potentially enable MRI "in open space" without a perfect Faraday shielded room to block out colored EM noise, because perturbing fields could be sensed and cancelled through active noise cancelling (with fast optical signal transmission and processing). For a scanner-independent "own-product" solution, existing MRI scanners may be equipped with such a magnetic field mapping system post market entrance, because none of the components at the scanner bore may notably interact with the magnetic field or RF radiation and the sensors may be made very small and thin, including the optic fibre cabling. Such sensors could be attached to the inside of an MRI bore without much trouble using, e.g., a thin adhesive foil.

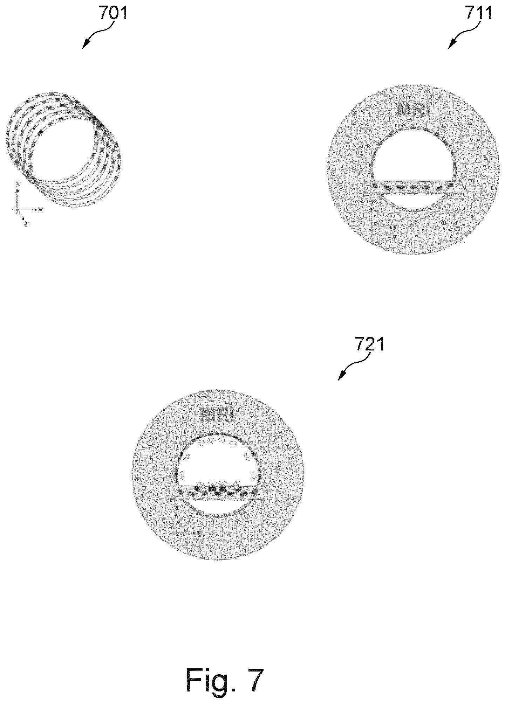

Fig. 7 illustrates examples of quantum sensor arrangements 701, 711 and 721 for motion detection in accordance with the present subject matter.

In the quantum sensor arrangement 701, the quantum sensors (with µm-mm size) shown as small black rectangles may be arranged as an array of rings in the x-y-plane and stacked for a cylindrical coverage along the z-axis (patient bore axis).

As shown with the x-y-view of the MRI apparatus, in the quantum sensor arrangement 711, the quantum sensors, shown as small black rectangles within the MRI apparatus, are provided as a quantum sensor ring construction within the bore, e.g., just underneath the plastic cover, of the MRI apparatus.

In the quantum sensor arrangement 721, the quantum sensors, shown as small black rectangles within the MRI apparatus, may be combined with a single or multiple distributed RF transmitters to enable radio type motion sensing by analyzing the backscattered signal and using the Doppler effect. The RF transmitters are represented as antenna symbols in Fig. 7. As shown with the x-y-view of the MRI apparatus, in the quantum sensor arrangement 721, quantum sensors provide a 3D coverage around the patient and are placed, e.g., in the patient bed, around the outside of the MRI bore. The quantum sensors may also be placed on pickup coil equipment (e.g., head coil) for additional field information. The RF transmitters may be placed in a similar way as the quantum sensors. For example, each RF transmitter is placed near a respective quantum sensor.

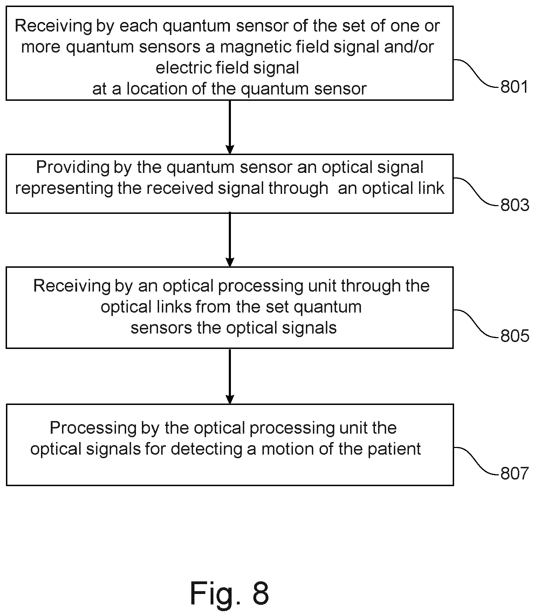

Fig. 8 is a flowchart of a method for motion detection. For the purpose of explanation, the method described in Fig. 8 may be implemented in the system illustrated in Fig. 1, but is not limited to this implementation.

Each quantum sensor of the set of quantum sensors may receive in step 801 a magnetic resonance signal and/or electric field signal at a location of the quantum sensor. Each quantum sensor may provide or output through an optical link 135 in step 803 an optical signal representing the received signal. An optical processing unit 134 may receive in step 805 through the optical links 135 from the set quantum sensors the optical signals. The optical processing unit may process in step 807 the optical signals for detecting a motion of the patient 128.

One example application of the method of Fig. 8 may cover detecting (unwanted) patient motion, e.g., of individual body parts and possible MRI acquisition control based on patient motion and breathing (gated/triggered acquisition). Also, the obtained motion information may be used in reconstruction for retrospective motion correction, like motion event timestamps or motion vector fields. In one example, not only patient motion may be detected, but also hardware motion. Due to the high bandwidth of the quantum sensors, all relevant frequencies of mechanical vibrations induced in the scanner hardware by the gradient coils may be detectable. Filtering the high frequency components of the quantum sensor signal may allow for automated supervision of hardware health in real time during patient scanning. This can be used for predictive maintenance purposes by, e.g., letting an artificial intelligence (Al) algorithm detect unusual behaviour or changes in the usually expected vibrational spectra during a scan, informing the operator of such events if possibly relevant for patient safety or image quality. This type of motion sensing technology may be applied to other systems and environments to detect human or hardware motion.

## Claims

1. A magnetic resonance imaging, MRI, coil assembly comprising:
a set of one or more quantum sensors and associated set of one or more radio frequency coils respectively;
wherein each radio frequency coil of the set of one or more radio frequency coils is configured to perform radio frequency excitation in an object to be imaged for inducing a magnetic resonance signal from the object;
wherein each quantum sensor of the set of one or more quantum sensors is configured to receive a signal induced by the magnetic resonance signal in the respective radio frequency coil and provide an optical signal representing the MRI signal through an optical link;
and
an optical signal processing unit being configured to receive through the optical links from the set of one or more quantum sensors the one or more optical signals and to digitize the one or more optical signals.

2. The MRI coil assembly of claim 1, the induced signal from the RF coil being a magnetic field signal, an electric field signal or an electromagnetic signal.

3. The MRI coil assembly of claim 2, wherein the set of one or more radio frequency coils are arranged such that the electric field signal is a linearly polarized electric field signal and the magnetic field signal is a linearly polarized magnetic field signal.

4. The MRI coil assembly of any of the preceding claims, the set of one or more quantum sensors being an array of quantum sensors, wherein the optical signal processing unit is configured to process the optical signals using a quantum sensitivity map, QSM.

5. The MRI coil assembly of any of the preceding claims, wherein each quantum sensor is electrically and/or magnetically coupled with the respective RF coil.

6. The MRI coil assembly of any of the preceding claims, wherein the quantum sensor is placed inside or beside the respective RF coil in order to receive the magnetic field signal.

7. The MRI coil assembly of any of the preceding claims, wherein the quantum sensor is placed inside a capacitor of the respective RF coil in order to receive the electric field signal.

8. The MRI coil assembly of any of the preceding claims, wherein the set of quantum sensors is configured to be deactivated during RF excitation.

9. The MRI coil assembly of claim 8, wherein the set of quantum sensors is configured to be deactivated using a shield circuit, the shield circuit being configured to be switched on for deactivating the set of quantum sensors and switched off for activating the set of quantum sensors.

10. The MRI coil assembly of claim 9, wherein the shield circuit is configured to be switched on and off by a PIN switch a Field-effect transistor, FET, switch, or a Micro-Electro-Mechanical Systems (MEMS) sensor.

11. The MRI coil assembly of any of the preceding claims, the quantum sensor being an Optically pumped magnetometer (OPM) or a solid state spin defect-based quantum sensor.

12. The MRI coil assembly of any of the preceding claims, the optical signal processing unit comprising a spectrometer for the digitization of the optical signal and a processing unit for creating the k-space data from the digitized signals.

13. An MRI apparatus comprising the MRI coil assembly of any of the preceding claims and a magnet assembly configured to generate a magnetic field in an inner space of the magnet assembly, to be applied to the object.

14. The apparatus of claim 13, wherein the optical signal processing unit is remotely located from the set of quantum sensors at a specific location such that a strength of the magnetic field of the MRI apparatus at the location is smaller than a magnetic field threshold and/or an acoustic noise level of the MRI apparatus at the location is smaller than a noise threshold.

15. A method for a magnetic resonance imaging, MRI, coil assembly, the MRI coil assembly comprising: a set of one or more quantum sensors and associated set of one or more radio frequency coils respectively; wherein each radio frequency coil of the set of one or more radio frequency coils is configured to perform radio frequency excitation in an object to be imaged for inducing a magnetic resonance signal from the object, the method comprising:
receiving by each quantum sensor of the set of one or more quantum sensors a signal induced by the magnetic resonance signal in the respective radio frequency coil;
providing by the quantum sensor an optical signal representing the MRI signal through an optical link;
receiving by an optical processing unit through the optical links from the set of one or more quantum sensors the one or more optical signals;
digitizing by the optical processing unit the one or more optical signals.

16. A computer program for a magnetic resonance imaging, MRI, coil assembly, the MRI coil assembly comprising: a set of one or more quantum sensors and associated set of one or more radio frequency coils respectively; wherein each radio frequency coil of the set of one or more radio frequency coils is configured to perform radio frequency excitation in an object to be imaged for inducing a magnetic resonance signal from the object, the computer program comprising machine executable instructions configured for causing a computational system to control the set of one or more quantum sensors and an optical processing unit to perform the method of claim 15.
